# EUROPÄISCHE PATENTANMELDUNG

(11) **EP 4 438 986 A1**
(43) Veröffentlichungstag der Anmeldung: **02.10.2024**
(21) Anmeldenummer: 23164297.6
(22) Anmeldetag: 27.03.2023
(51) Int. Cl.: F28D 15/02

(54) **FALTBARE KÜHLVORRICHTUNG, UMRICHTER, FALTBARES ELEKTRONIKGERÄT UND SIMULATIONSPROGRAMMPRODUKT**

(71) Anmelder: Siemens Aktiengesellschaft, 80333 München (DE)
(72) Erfinder: Schwarz, Florian, 90766 Fürth (DE)
(74) Vertreter: Siemens Patent Attorneys

(57) **Zusammenfassung**

Die Erfindung betrifft eine Kühlvorrichtung (30), die einen ersten und einen zweiten Abschnitt (10, 20) umfasst, die jeweils plattenförmig ausgebildet sind. In den Abschnitt (10, 20) ist jeweils zumindest ein Kanal (12, 22) für ein Kühlfluid (25) ausgebildet, wobei der erste und zweite Abschnitt (10, 20) über eine Biegestruktur (40) um eine Biegeachse (15) relativ zueinander wiederholt schwenkbar verbunden sind. Erfindungsgemäß ist die Biegestruktur (40) zu einem Ausüben einer Rückstellkraft in einem gebogenen Zustand ausgebildet und weist zumindest einen Kanal (12) im ersten Abschnitt (10) auf, der mit einem Kanal (22) im zweiten Abschnitt (20) hydraulisch verbunden ist. Die Erfindung betrifft ebenso einen Umrichter (50) und ein faltbares Elektronikgerät (60), die jeweils mit einer solchen Kühlvorrichtung (30) ausgestattet sind. Ferner betrifft die Erfindung ein Simulationsprogrammprodukt (70), das zum Simulieren eines Betriebsverhaltens einer entsprechenden Kühlvorrichtung (30) ausgebildet ist.

## Beschreibung

Die Erfindung betrifft eine Kühlvorrichtung, die faltbar ist und einen Umrichter, der mit einer solchen Kühlvorrichtung ausgestattet ist. Weiter betrifft die Erfindung ein faltbares Elektronikgerät, das über eine derartige Kühlvorrichtung verfügt und ein Simulationsprogrammprodukt, das zum Simulieren eines Betriebsverhaltens einer solchen Kühlvorrichtung ausgebildet ist.

Aus der Internationalen Anmeldung WO 2021/232134 A1 ist eine Heatpipe für ein elektronisches Gerät bekannt, die ein erstes und ein zweites Modul aufweist, die jeweils einen faltbaren Abschnitt aufweisen. Darin ist eine Polymerlage auf dem ersten und zweiten Modul angeordnet. In einem faltbaren Bereich sind Vorsprünge ausgebildet, die sich geradlinig erstrecken.

Die Druckschrift US 5,743,325 A1 offenbart einen bewegliches Radiatorpanel für einen Satelliten, das mit einem Scharnier an einem stationären Radiatorpanel befestigt ist. In beiden Radiatorpanelen sind Kanäle von Heatpipes ausgebildet, die hydraulisch miteinander verbunden sind. Die Kanäle der Heatpipes in den Radiatorpanelen sind über eine Rohrleitung miteinander verbunden, die eine mehrfache Schlaufenform aufweist. Die Rohrleitung ist aus einem biegbaren Metall hergestellt.

Kühlvorrichtungen werden in einer Vielzahl an Geräten eingesetzt, an denen zunehmend Verluste in Form von Wärme anfallen. Dementsprechend besteht eine steigende Anforderung an die thermische Leistungsfähigkeit von Kühlvorrichtungen. Gleichzeitig besteht die Zielsetzung, Geräte kompakt auszubilden, so dass eine durchgängig flächige Bauform diese Anforderung schlechter erfüllen kann. Weiter werden zunehmend Geräte gefordert, die faltbar sind. Ebenso wird eine schnelle, einfache und kosteneffiziente Herstellung von Kühlvorrichtungen angestrebt. Der Erfindung liegt die Aufgabenstellung zugrunde, eine Kühlvorrichtung bereitzustellen, die in zumindest einem der skizzierten Aspekte eine Verbesserung bietet.

Die Aufgabenstellung wird durch eine erfindungsgemäße Kühlvorrichtung gelöst, die einen ersten und einen zweiten Abschnitt umfasst, die jeweils im Wesentlichen plattenförmig ausgebildet sind. Der erste und zweite Abschnitt sind dazu geeignet, beim Betrieb der Kühlvorrichtung als sogenannte Warmseite bzw. Kaltseite zu dienen. Im ersten und zweiten Abschnitt ist jeweils zumindest ein Kanal ausgebildet, der für ein Kühlfluid geeignet ist. Das Kühlfluid kann eine Flüssigkeit, ein Gas, ein Dampf, oder ein Gemisch hieraus sein. Der erste und zweite Abschnitt sind über eine Biegestruktur miteinander verbunden, die um eine Biegeachse biegbar ist. Mittels der Biegestruktur sind der erste und zweite Abschnitt relativ zueinander schwenkbar. Des Weiteren ist die Biegestruktur zu einem wiederholten Biegen ausgebildet, beispielsweise für über 10.000 Biegezyklen. Erfindungsgemäß ist die Biegestruktur dazu ausgebildet, in einem gebogenen Zustand eine Rückstellkraft auszuüben. Die Biegestruktur kann derart ausgebildet sein, dass in einem Biegezyklus zumindest überwiegend elastische Verformungen in der Biegestruktur vorliegen. Die Biegestruktur ist ebenso dazu ausgebildet, zumindest einen Kanal im ersten Abschnitt mit zumindest einem Kanal im zweiten Abschnitt hydraulisch zu verbinden. Dazu kann in der Biegestruktur selbst ein Kanal ausgebildet sein, der zwischen den Kanälen im ersten und zweiten Abschnitt angeordnet ist.

Die erfindungsgemäße Kühlvorrichtung ist dazu geeignet, auch Biegewinkel wiederholt zu erreichen, bei denen der erste und zweite Abschnitt im Wesentlichen gegenüberliegen. Gleichzeitig ist ein Kühlbetrieb durch die hydraulische Verbindung zwischen dem ersten und zweiten Abschnitt bei jeglichem erreichbaren Biegewinkel gewährleistet. Ferner ist in der beanspruchten Kühlvorrichtung eine breite Spanne an Kühlkonzepten umsetzbar. Ebenso ist die Biegestruktur, und damit auch die erfindungsgemäße Kühlvorrichtung, miniaturisierbar.

In einer Ausführungsform der beanspruchten Kühlvorrichtung ist die Biegestruktur einstückig mit dem ersten und zweiten Abschnitt ausgebildet. Die Biegestruktur kann beispielsweise in der gleichen Bauweise wie der erste und zweite Abschnitt hergestellt sein. Insbesondere können die Biegestruktur, der erste und zweite Abschnitt in einer Schichtbauweise hergestellt sein. Weiter kann die Biegestruktur plattenförmig, also flächig, ausgebildet sein. Hierdurch ist der Kanal in der Biegestruktur mit den Kanälen im ersten und zweiten Abschnitt einstückig, so dass die Kühlvorrichtung mit einer reduzierten Anzahl an Dichtelementen, beispielsweise Gummidichtungen, ausgebildet sein kann. Dadurch ist ein zuverlässiger Kühlbetrieb gewährleistet.

In einer weiteren Ausführungsform der beanspruchten Kühlvorrichtung ist die Biegestruktur zur Reduzierung einer plastischen Verformung beim Biegen mäanderförmig oder mehrfach Z-förmig ausgebildet. Die Biegestruktur kann insbesondere eine mehrfache Schlaufenform aufweisen, die eine gesteigerte wiederholbare Biegsamkeit bietet. Eine derartige Biegestruktur ist beispielsweise durch Fräsen oder Stanzen von plattenförmigen Halbzeugen herstellbar. Ebenso können mäanderförmige oder mehrfach Z-förmige Biegestrukturen eine bionisch optimierte Form aufweisen, wodurch deren wiederholbare Biegsamkeit weiter steigerbar ist. Dadurch ist insbesondere die Biegesteifigkeit der Biegestruktur mit einem erhöhten Grad an konstruktiver Freiheit vorgebbar. Alternativ kann die Biegestruktur als eine Mehrzahl an verbundenen umlaufenden Strukturen ausgebildet sein. Unter umlaufenden Strukturen sind hierbei geschlossene Strukturen zu verstehen, beispielsweise rechteckige Rahmen. Die verbundenen umlaufenden Strukturen können versetzt angeordnet sein, wodurch die Biegsamkeit der Biegestruktur einstellbar ist. Umlaufende Strukturen zeigen eine höhere Biegesteifigkeit als gleich dimensionierte Strukturen mit offenen Formen. Bei gleichem Materialeinsatz wie bei offenen Strukturen ist mit verbundenen umlaufenden Strukturen eine gesteigerte Biegesteifigkeit erzielbar. Dadurch ist die Biegestruktur, und damit die beanspruchte Kühlvorrichtung, ein einfacher Weise an eine breite Spanne an Einsatzzwecken bedarfsgerecht anpassbar.

Des Weiteren kann die Biegestruktur der Kühlvorrichtung Längsstege umfassen, die sich im Wesentlichen entlang der Biegeachse erstrecken. Der Längssteg folgt damit im Wesentlichen einer Kante des ersten und/oder zweiten im Wesentlichen plattenförmigen Abschnitts der Kühlvorrichtung. Die Biegeachse stellt eine Achse dar, um die die Kühlvorrichtung im Bereich der Biegestruktur bestimmungsgemäß wölbbar, also biegbar, ist. Alternativ kann die Biegestruktur Z-Stege umfassen, die sich in einem gebogenen Zustand im Wesentlichen windschief zur Biegeachse erstrecken. In einem ungebogenen Zustand der Biegestruktur sind die Z-Stege zwischen Kanten des ersten und zweiten Abschnitts der Kühlvorrichtung im Wesentlichen diagonal ausgerichtet. Die Z-Stege können unmittelbar, also ohne Querstege, miteinander verbunden sein. Zumindest einer der Z-Stege kann mit dem ersten bzw. zweiten Abschnitt der Kühlvorrichtung verbunden sein. Z-Stege bieten eine erhöhte Biegsamkeit der Biegestruktur bei minimalem Materialeinsatz, also reduziertem Gewicht. Dadurch wird die konstruktive Freiheit bei der Auslegung der beanspruchten Kühlvorrichtung weiter erhöht und somit das mögliche Einsatzspektrum weiter vergrößert. Ebenso sind mehrere Z-Stege parallel zueinander ausbildbar, die ineinander verschachtelt angeordnet sind. Die Z-Stege können hierbei im Wesentlichen baugleich ausgebildet sein. Hierdurch sind der erste und zweite Abschnitt über mehrere im Wesentlichen gleiche Kanäle kompakt miteinander verbindbar. Die hydraulische Verbindung zwischen dem ersten und zweiten Abschnitt der Kühlvorrichtung ist somit in einfacher Weise in puncto Kühlfluidaustauschfähigkeit skalierbar.

Ferner kann die Kühlvorrichtung als planare Heatipie, als planare pulsierende Heatpipe oder als ein Thermosiphon ausgebildet sein. Der erste und/oder zweite Abschnitt, die im Wesentlichen plattenförmig sind, können dementsprechend als Hohlkörper für ein Verdampfen bzw. Kondensieren für das Kühlfluid ausgebildet sein, die über Kanäle miteinander verbunden sind. Die beanspruchte Kühlvorrichtung ist somit in unterschiedlichen thermischen Bauformen ausführbar, die für unterschiedliche Temperaturregimes bevorzugt sind. Auch hierdurch wird das mit der beanspruchten Kühlvorrichtung abgedeckte Spektrum an Anwendungen weiter verbreitert. Weiter kann die Kühlvorrichtung eine Mehrzahl an Biegestrukturen aufweisen, die zwischen dem ersten und zweiten Abschnitt angeordnet sind. Die Biegestrukturen können dabei im Wesentlichen baugleich ausgebildet sein. Die Kühlleistung der Kühlvorrichtung ist infolgedessen skalierbar. Ebenso sind komplexe Kühlarchitekturen verwirklichbar. Auch hierdurch wird das mögliche Einsatzspektrum der beanspruchten Kühlvorrichtung weiter verbreitert.

In einer weiteren Ausführungsform der beanspruchten Kühlvorrichtung kann die Biegestruktur eine Mehrzahl an Querkanälen aufweisen, durch die beispielsweise Längsstege oder Z-Stege miteinander hydraulisch verbunden sind. Die Querkanäle sind in entsprechenden Querungsabschnitten innerhalb der Biegestruktur ausgebildet, die jeweils beispielsweise zwei Längsstege oder zwei Z-Stege verbinden können. Die Querkanäle sind dazu ausgebildet und positioniert, einer Fluidströmung des Kühlfluids eine Vorzugsrichtung zwischen dem ersten und zweiten Abschnitt der Kühlvorrichtung aufzuprägen. Die Querkanäle, und korrespondierend die Querungsabschnitte, können winkelig oder im Wesentlichen bogenförmig ausgebildet sein. Dadurch sind beispielsweise Kühlvorrichtungen erzielbar, bei denen über einen Bereich der Biegestruktur Kühlfluid vom ersten zum zweiten Abschnitt fließt und in einem anderen Bereich vom zweiten zum ersten Bereich. Alternativ oder ergänzend kann die Biegestruktur abschnittsweise als Teslaventil ausgebildet sein. Dazu kann ein Längssteg oder Z-Steg selbst in Form eines Teslaventils ausgebildet sein. Alternativ oder ergänzend kann der Kanal im Längssteg oder im Z-Steg in Form eines Teslaventils ausgebildet sein. Auch durch das Teslaventil wird der Fluidströmung des Kühlfluids eine Vorzugsrichtung aufgeprägt. Teslaventile sind frei von beweglichen Teilen und erlauben in einfacher Weise das Aufprägen einer Vorzugsrichtung der Fluidströmung. Gleichzeitig bieten Teslaventile aufgrund ihres abschnittsweise umlaufenden Aufbaus eine gesteigerte Biegesteifigkeit. Mit der beanspruchten Kühlvorrichtung ist somit eine Vielzahl an abgeschlossenen kühlfluidbasierten Kühlkonzepten verwirklichbar.

Darüber hinaus kann im ersten Abschnitt, im zweiten Abschnitt und/oder in der Biegestruktur ein erster Kanal mit einer ersten Breite ausgebildet sein und ein zweiter Kanal mit einer zweiten Breite. Unter Breite ist hierbei eine Abmessung des Querschnitts des entsprechenden Kanals zu verstehen, die sich im Wesentlichen parallel zu einer Kante des ersten oder zweiten Abschnitts erstreckt. Die erste Breite ist hierbei geringer als die zweite Breite. Durch ein Variieren der Breite der Kanäle ist deren hydraulischer Querschnitt vorgebbar. Gleichzeitig wird, bei gleichbleibender Höhe und Wandstärke, die Biegesteifigkeit durch eine erhöhte Breite nur verhältnismäßig gering gesteigert. Demzufolge sind die hydraulischen Querschnitte der Kanäle in der beanspruchten Kühlvorrichtung in einfacher Weise anpassbar, ohne dabei die mechanischen Eigenschaften der Biegestruktur, insbesondere deren Biegesteifigkeit, zu verändern. Folglich sind der hydraulische Querschnitt der Kanäle und die Biegeeigenschaften der Biegestruktur nahezu entkoppelt. Die beanspruchte Kühlvorrichtung ist somit in einfacher Weise konstruktiv anpassbar. Darüber hinaus ist durch die hydraulischen Querschnitte von Kanälen eine Vorzugsströmungsrichtung vorgebbar und/oder eine Strömungsgeschwindigkeit des Kühlfluids im entsprechenden Kanal beschleunigen oder verzögern.

In der beanspruchten Kühlvorrichtung kann die Biegestruktur die im Wesentlichen gleiche Dicke aufweisen wie der erste und zweite Abschnitt. Die Dicke ist hierbei als die Abmessung aufzufassen, die ein Plattenstärke bei den im Wesentlichen plattenförmigen Abschnitten der Kühlvorrichtung entspricht. Der erste Abschnitt, der zweite Abschnitt und die Biegestruktur sind dadurch in einem ungebogenen Zustand aus einem flächigen Halbzeug fertigbar. Die Herstellung der Biegestruktur ist dadurch in die Fertigung des ersten und zweiten Abschnitts integrierbar, wodurch ein erhöhter Grad an Fertigungsautomatisierung erzielbar ist. Beispielsweise kann die Kühlvorrichtung bei ihrer Herstellung auf einem flachen Fertigungsbett aufgebaut werden und mit einem flachen Stempel verpresst werden. Alternativ oder ergänzend ist die beanspruchte Kühlvorrichtung aufgrund ihrer Plattenform schnell mittels additiver Fertigung herstellbar. Die beanspruchte Kühlvorrichtung ist somit kosteneffizient und prozesssicher fertigbar. Ebenso ist eine solche Kühlvorrichtung kompakt ausbildbar, wodurch diese auch für den Einsatz in Geräten mit geringer Bauhöhe, wie beispielsweise in faltbaren Elektronikgeräten wie Smartphones, Tablets oder Notebooks, geeignet ist.

Insbesondere kann der Kanal, der in der Biegestruktur ausgebildet ist, durch zumindest eine Decklage aus einem Dielektrikum entlang einer Aufbaurichtung begrenzt sein. Die Aufbaurichtung ist hierbei die Richtung, entlang der die Dicke des ersten oder zweiten Abschnitts zu messen ist. Durch die Decklage können der erste Abschnitt, der zweite Abschnitt und/oder die Biegestruktur im Wesentlichen nach einer Seite flächig verschlossen sein und einen Austritt von Kühlfluid verhindern. Die Decklage kann bei der Herstellung der Kühlvorrichtung als flächiges Halbzeug aufgebracht werden. Dies erlaubt eine schnelle Fertigung und gewährleistet einen zuverlässigen Einschluss des Kühlfluids.

In einer weiteren Ausführungsform der beanspruchten Kühlvorrichtung kann der Kanal in der Biegestruktur mit einer Gasbarriere-Schicht beschichtet sein. Eine derartige Gasbarriere-Schicht minimiert ein Eindringen von Ausdünstungen und Gasen in das Kühlfluid. Die Gasbarriere-Schicht kann insbesondere bei einem additiven Fertigen der Biegestruktur in einfacher Weise hergestellt werden. Die Biegestruktur, in damit die beanspruchte Kühlvorrichtung, bietet so eine erhöhte thermische Leistungsfähigkeit über eine erhöhte Einsatzdauer.

In der beanspruchten Kühlvorrichtung können der erste und/oder zweite Abschnitt zumindest teilweise aus einem Kunststoff, einem Kunstharz oder einem Verbundwerkstoff mit einem Kunstharz, insbesondere aus FR4, hergestellt sein. Derartige Werkstoffe sind Dielektrika und bieten eine zuverlässige elektrische Isolation. Die Kühlvorrichtung ist somit auch in Anwendungen einsetzbar, in denen mit erhöhten elektrischen Spannungen und/oder elektrischen Strömen zu rechnen ist, beispielsweise in Umrichtern. Ferner bieten derartige Werkstoffe eine vorteilhafte wiederholte Biegsamkeit und Bearbeitbarkeit. Ebenso ist eine Kühlvorrichtung, die aus einem derartigen Werkstoff, insbesondere einem Kunststoff, hergestellt ist, mittels additiver Fertigung herstellbar.

Darüber hinaus können der erste und/oder zweite Abschnitt der beanspruchten Kühlvorrichtung eine Leiterlage umfassen. Der erste und/oder zweite Abschnitt können dabei einen Schichtaufbau aufweisen, wobei die Leiterlage aus einem elektrisch leitenden Material hergestellt ist. Dementsprechend können der erste und/oder zweite Abschnitt in einem entsprechenden Bereich mit einer Leiterlage als Leiterplatte ausgebildet sein. Die Leiterlage kann durch ein Dielektrikum vom Kühlfluid elektrisch isoliert sein. Alternativ oder ergänzend kann das Kühlfluid als elektrisch nichtleitende Flüssigkeit ausgebildet sein. Weiter alternativ oder ergänzend können der erste und/oder zweite Abschnitt mit einem surface-mounteddevice-Element, kurz SMD-Element, versehen sein. Der erste und/oder zweite Abschnitt können an ihrer äußeren Oberfläche entsprechend elektrisch kontaktiert sein. Die beanspruchte Kühlvorrichtung erlaubt es damit, darin auch einen elektrischen Aufbau zu integrieren. In der beanspruchten Kühlvorrichtung ist somit eine verbesserte thermische Anbindung an zu entwärmende elektrische Elemente bereitstellbar und gleichzeitig ein besonders kompakter Aufbau erzielbar.

Die eingangs beschriebene Aufgabenstellung wird ebenso durch ein erfindungsgemäßes faltbares Elektronikgerät gelöst. Das faltbare Elektronikgerät ist als Smartphone, als Tablet oder Notebook ausgebildet und umfasst einen ersten und einen zweiten Geräteabschnitt, die relativ zueinander schwenkbar ausgebildet sind. Im faltbaren Elektronikgerät ist eine Kühlvorrichtung angeordnet, die zu einem Wärmetransport vom ersten Geräteabschnitt zum zweiten Geräteabschnitt ausgebildet ist. Erfindungsgemäß ist die Kühlvorrichtung gemäß zumindest einer der oben beschriebenen Ausführungsformen ausgebildet. Die Kühlvorrichtung ist kompakt, bietet eine erhöhte Kühlleistung, erzielbare Einsatzdauer und Wirtschaftlichkeit. Basierend auf der beanspruchten Kühlvorrichtung sind faltbare Elektronikgeräte herstellbar, bei denen im ersten Geräteabschnitt erhöhte Wärmeverluste auftreten, die zu einer Wärmesenke, beispielsweise einem Kühlkörper, im zweiten Geräteabschnitt zu transportieren sind. Dadurch sind insgesamt leistungsfähigere faltbare Elektronikgeräte mit dauerhaft ausreichender zuverlässiger Kühlung herstellbar. Die technische Leistungsfähigkeit faltbarer Elektronikgeräte wird so weiter gesteigert.

Ebenso wird die Aufgabenstellung durch einen erfindungsgemä-ßen Umrichter gelöst, der eine Mehrzahl an Leistungshalbleitern und Kondensatoren umfasst, die elektrisch miteinander verbunden sind. Der Umrichter weist ebenso eine Kühlvorrichtung auf, die zu einem Entwärmen der Leistungshalbleiter und/oder der Kondensatoren ausgebildet und angeordnet ist. Erfindungsgemäß ist die Kühlvorrichtung nach einer der oben dargestellten Ausführungsformen ausgebildet. Der Umrichter kann zumindest eine Leiterplatten umfassen, auf der jeweils Leistungshalbleiter und/oder Kondensatoren angebracht sind. Die Leiterplatte kann über die Kühlvorrichtung in eine Wärmesenke entwärmt werden. Die Leiterplatte und die zugehörige Wärmesenke können winkelig zueinander angeordnet sein. Unter einer winkeligen Anordnung ist eine Anordnung zu verstehen, die nicht im Wesentlichen in einer Ebene liegt, also sich nicht entlang einer durchgängigen Hauptrichtung erstreckt. Durch die beanspruchte Kühlvorrichtung sind die Leistungshalbleiter und Kondensatoren unabhängig von einer Ausrichtung der Wärmesenke platzierbar. Die hierdurch gewonnene konstruktive Freiheit erlaubt es, den beanspruchten Umrichter kompakt auszubilden.

Ferner wird die eingangs skizzierte Aufgabenstellung durch ein erfindungsgemäßes Simulationsprogrammprodukt gelöst, das das zu einem Simulieren eines Betriebsverhaltens einer Kühlvorrichtung ausgebildet ist. Das Simulationsprogrammprodukt umfasst hierzu Befehle, die einen Computer bei ihrer Ausführung dazu veranlassen, das Betriebsverhalten der Kühlvorrichtung zu simulieren. Die Kühlvorrichtung weist einen ersten und einen zweiten Abschnitt auf, die im Wesentlichen plattenförmig ausgebildet sind und ist dazu ausgebildet, Wärme vom ersten zum zweiten Abschnitt zu transportieren. Das Betriebsverhalten umfasst ein thermisches Verhalten der Kühlvorrichtung und kann unter anderem das Nachstellen einer Wärmefreisetzung am ersten Abschnitt der Kühlvorrichtung so wie die Übertragung der freigesetzten Wärme in den ersten Abschnitt der Kühlvorrichtung. Ebenso kann das thermische Verhalten ein Erwärmungsverhalten, ein Verdampfungsverhalten, ein Kondensationsverhalten und/oder ein Fließverhalten eines Kühlfluids in der Kühlvorrichtung umfassen. Weiter kann das thermische Verhalten ein Nachstellen eines Wärmeübergangs aus dem Kühlfluid in den zweiten Abschnitt umfassen. Das Betriebsverhalten kann dynamisch, quasi-stationär oder stationär nachgestellt sein. Die nachgestellten, also simulierten Wärmefreisetzungen, Wärmeleitung, Wärmeübertragungen, sowie die daraus resultierende Temperaturverteilung an und/oder in der Kühlvorrichtung können durch das Simulationsprogrammprodukt ausgegeben werden. Ferner kann ein mechanisches Verhalten der Kühlvorrichtung bei einem Biegen um ihre Biegestruktur ebenso zum Betriebsverhalten gehören. In Abhängigkeit von einer vorliegenden Biegung der Kühlvorrichtung und ihrer Ausrichtung kann sich schwerkraftbedingt ein verändertes Fließverhalten des Kühlfluids einstellen, das ebenfalls simuliert werden kann. Erfindungsgemäß ist die Kühlvorrichtung gemäß einer der oben skizzierten Ausführungsformen ausgebildet. Der Erfindung liegt unter anderem die Erkenntnis zugrunde, dass eine Funktionsweise einer derartigen Kühlvorrichtung in überraschend einfacher Weise basierend auf einer Simulation einer ebenen und/oder geradlinigen Kühlvorrichtung, beispielsweise einer Heatpipe, nachstellen lässt. In Abhängigkeit von der Lage und der Biegung der Kühlvorrichtung ist die auf das Kühlfluid einwirkende Schwerkraft als in seiner Orientierung lokal veränderlicher Vektor darstellbar, der mit der Simulation der ebenen bzw. geradlinigen Kühlvorrichtung überlagert wird. Hierdurch ergibt sich in überraschend einfacher Weise eine präzise Simulation der entsprechenden Kühlvorrichtung. Das beanspruchte Simulationsprogrammprodukt kommt mit reduzierter Rechenleistung aus und erlaubt eine Modellierung mit verringertem Rechenaufwand. Die zugrundeliegende Kühlvorrichtung ist mit dem beanspruchten Simulationsprogrammprodukt im Wesentlichen in Echtzeit nachstellbar, also simulierbar.

Ebenso ist mittels des beanspruchten Simulationsprogrammprodukts eine Mehrzahl an Kühlvorrichtungen in ihrem jeweiligen Betriebsverhalten mit akzeptablem Rechenaufwand simulierbar. Hierdurch sind insbesondere Kühlvorrichtung während eines Betriebs überwachbar, in dem diese ihre Lage und/oder ihre Biegung verändern. Insbesondere sind mittels Sensoren erfasste Temperaturen und/oder Temperaturverteilung an derartigen Kühlvorrichtungen über das Simulationsprogrammprodukt auf Plausibilität prüfbar, so dass defekte Kühlvorrichtungen schneller erkennbar sind. Hierdurch ist ein schädlicher Betrieb eines Geräts, das mit der defekten Kühlvorrichtung ausgestattet ist, vermeidbar. Ferner kann das Simulationsprogrammprodukt über eine Datenschnittstelle verfügen, über die Messwerte zu Temperaturen an und/oder in der Kühlvorrichtung als Eingaben vorgebbar sind, und/oder Angaben zu Wärmeströmen am ersten und/oder zweiten Abschnitt der entsprechenden Kühlvorrichtung. Alternativ oder ergänzend kann das Simulationsprogrammprodukt eine Datenschnittstelle zum Ausgeben von Simulationsergebnissen aufweisen, beispielsweise an andere simulationsgerichtete Computerprogramme, insbesondere den Digitalen Zwilling des Geräts, das mit der zugrundeliegenden Kühlvorrichtung ausgestattet ist.

Das Simulationsprogrammprodukt kann als sogenannter Digitaler Zwilling einer entsprechenden Kühlvorrichtung ausgebildet sein. Der Digitale Zwilling ist bei einem Simulieren eines Betriebsverhaltens eines korrespondierend eingesetzten Kühlvorrichtung verwendbar. Der Digitale Zwilling kann beispielsweise gemäß US 2017/268572 A1 ausgebildet sein. Der Offenbarungsgehalt von US 2017/268572 A1 wird durch Verweisung in die vorliegende Anmeldung miteinbezogen. Das Simulationsprogrammprodukt kann ferner dazu ausgebildet sein, Steuerbefehle auszugeben, mit denen ein Gerät ansteuerbar ist, mit dem die Kühlvorrichtung ausgestattet ist. Beispielsweise kann durch den Steuerbefehl das entsprechende Gerät derart betrieben werden, dass bei einer vorliegenden defekten Kühlvorrichtung ein Betrieb eingeleitet wird, bei dem die anfallenden Wärmeverluste reduziert sind.

Die Erfindung wird im Folgenden anhand einzelner Ausführungsformen in Figuren näher erläutert. Die Figuren sind insoweit in gegenseitiger Ergänzung zu lesen, dass gleiche Bezugszeichen in unterschiedlichen Figuren die gleiche technische Bedeutung haben. Die Merkmale der einzelnen Ausführungsformen sind untereinander auch kombinierbar. Ferner sind die Merkmale der in den Figuren gezeigten Ausführungsformen mit den oben skizzierten Merkmalen kombinierbar. Es zeigen im Einzelnen:
- FIG 1: eine erste Ausführungsform der beanspruchten Kühlvorrichtung im ungebogenen Zustand in einer Draufsicht;
- FIG 2: eine zweite Ausführungsform der beanspruchten Kühlvorrichtung im ungebogenen Zustand in einer Draufsicht;
- FIG 3: eine dritte Ausführungsform der beanspruchten Kühlvorrichtung im ungebogenen Zustand in einer Draufsicht;
- FIG 4: eine vierte Ausführungsform der beanspruchten Kühlvorrichtung im ungebogenen Zustand in einer Draufsicht;
- FIG 5: eine fünfte Ausführungsform der beanspruchten Kühlvorrichtung im ungebogenen Zustand in deiner Draufsicht;
- FIG 6: eine sechste Ausführungsform der beanspruchten Kühlvorrichtung im ungebogenen Zustand in deiner Draufsicht;
- FIG 7: eine siebente Ausführungsform der beanspruchten Kühlvorrichtung im ungebogenen Zustand in deiner Draufsicht;
- FIG 8: eine Ausführungsform eines beanspruchten faltbaren Elektronikgeräts in einer Schrägansicht;
- FIG 9: eine Ausführungsform eines beanspruchten Umrichters in einer Längsschnittansicht.

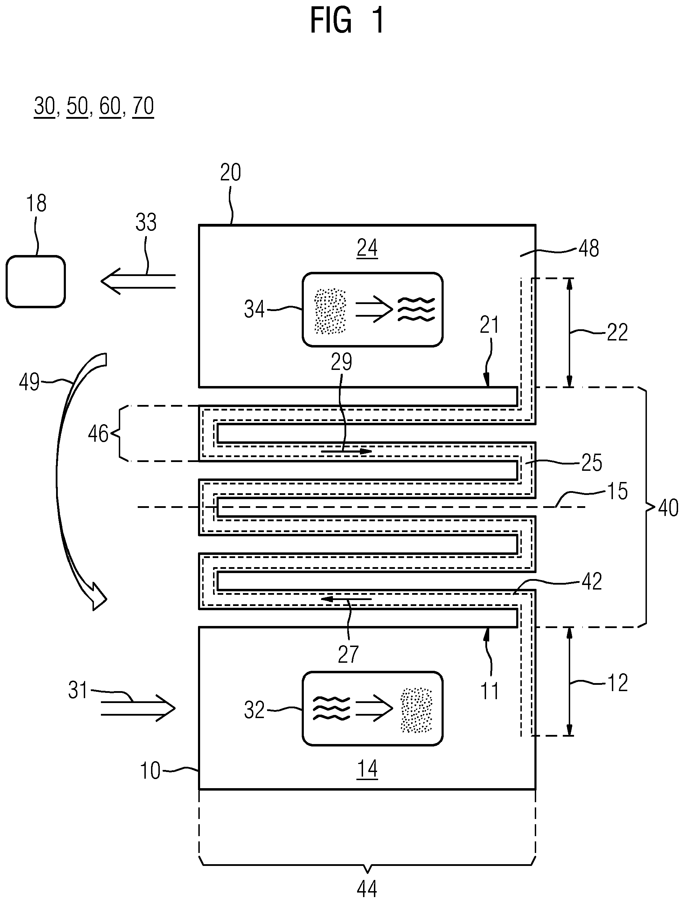

Eine erste Ausführungsform der beanspruchten Kühlvorrichtung 30, die einen ersten Abschnitt 10 und einen zweiten Abschnitt 20 umfasst, die über eine Biegestruktur 40 miteinander verbunden sind, ist in FIG 1 in einer Draufsicht gezeigt. Der erste und zweite Abschnitt 10, 20 sind im Wesentlichen plattenförmig ausgebildet und weisen im Wesentlichen die gleiche Dicke auf. Die Kühlvorrichtung 10 ist in FIG 1 in einem ungebogenen Zustand dargestellt. Die Biegestruktur 40 ist einstückig mit dem ersten und zweiten Abschnitt 10, 20 ausgebildet und im ungebogenen Zustand auch im Wesentlichen plattenförmig. Der erste Abschnitt 10, der zweite Abschnitt 20 und die Biegestruktur 40 sind aus einem Werkstoff hergestellt, der zumindest teilweise aus Kunstharz 48 besteht. Die Biegestruktur 40 weist ebenso die im Wesentlichen gleiche Dicke wie der erste und zweite Abschnitt 10, 20 auf. Der erste Abschnitt 10 ist dazu geeignet, einen Wärmeeintrag 31 aufzunehmen und dadurch ein Kühlfluid 25 zu verdampfen. Eine solche Verdampfung 32 des Kühlfluids 25 ist in FIG 1 schematisch dargestellt. Der erste Abschnitt 10 ist zumindest teilweise als Hohlkörper ausgebildet, so dass der erste Abschnitt 10 ein Reservoir 14 für das Kühlfluid 25 bildet. Ebenso ist im ersten Abschnitt 10 ein Kanal 12 ausgebildet, durch den Kühlfluid 25 leitbar ist. Der Kanal 12 ist im Inneren des ersten Abschnitts 10 ausgebildet und ist hydraulisch mit einem Kanal 42 in der Biegestruktur 40 verbunden. Der Kanal 42 in der Biegestruktur 40 wiederum ist hydraulisch mit einem zweiten Kanal 22 im zweiten Abschnitt 20 hydraulisch verbunden. Hierdurch liegt insgesamt eine hydraulische Verbindung zwischen dem ersten und zweiten Abschnitt 10, 20, bzw. zwischen deren Kanälen 12, 22 vor. Der zweite Abschnitt 20 ist ebenso zumindest teilweise als Hohlkörper ausgebildet und bildet auch ein Reservoir 24 für das Kühlfluid 25. Der zweite Abschnitt 20 ist dazu ausgebildet, Wärme über eine Wärmeabfuhr 33 an eine nur schematisch gezeigte Wärmesenke 18 abzugeben. Der zweite Abschnitt 20 ist dazu ausgebildet, dampfförmiges Kühlfluid 25 zu kondensieren. Eine derartige Kondensation 34 ist in FIG 1 korrespondierend zur Verdampfung 32 schematisch gezeigt.

Die Biegestruktur 40 ist mäanderförmig ausgebildet und umfasst eine Mehrzahl an Längsstegen 44, die sich im Wesentlichen parallel zu einer Biegeachse 15 erstrecken, um die die Biegestruktur 40 wiederholt biegbar ist. Die Biegeachse 15 ist dabei im Wesentlichen parallel zu einer Kante 11, 21 des ersten und zweiten Abschnitts 10, 20 ausgerichtet. Die Längsstege 44 sind über Querstege 46 miteinander verbunden, so dass die Mäanderform der Biegestruktur 40 ausgebildet ist. Der Kanal 42 der Biegestruktur 40 erstreckt sich durch die Längsstege 44 und Querstege 46. Innerhalb des Kanals 42 der Biegestruktur 40 liegt für verdampftes Kühlfluid 25 eine erste Fließrichtung 27 vor und für kondensiertes Kühlfluid 25 eine entgegengesetzte zweite Fließrichtung 29. Dadurch und in Verbindung mit dem im Wesentlichen plattenförmigen ersten und zweiten Abschnitt bildet die Kühlvorrichtung 30 eine planare Zweiphasenkühlung, also eine planare Heatpipe oder planaren Thermosiphon. Die Mäanderform der Biegestruktur 40 macht diese um die Biegeachse 15 wiederholt biegbar. Insbesondere wird durch die Mäanderform mechanisch im Wesentlichen das Prinzip eines Balgs verwirklicht. Eine entsprechende Biegung ist in FIG 1 als Pfeil 49 versinnbildlicht. Die Biegestruktur 40 übt in einem gebogenen Zustand eine Rückstellkraft aus, durch die die Kühlvorrichtung 30 in den gezeigten ungebogenen Zustand zurückstrebt. Auch bei einem Biegen 49 um die Biegeachse um 90° oder mehr liegen in der Biegestruktur 40 überwiegend, bevorzugt ausschließlich, elastische Verformungen vor. Die Kühlvorrichtung 30 ist auch so weit wiederholt um die Biegeachse 15 biegbar, dass sich Oberflächen des ersten und zweiten Abschnitts 10, 20 gegenüberliegen. Durch die Form der Biegestruktur 40 ist eine Plastifizierung und/oder Rissbildung im Kunstharz 48 beim Biegen 49 minimiert, so dass die Biegestruktur 40 dazu geeignet ist, einer erhöhten Zahl an Biegezyklen standzuhalten. Die Biegestruktur 40 mit dem darin ausgebildeten Kanal 42 ist beispielsweise durch additive Fertigung herstellbar. Alternativ oder ergänzend kann die Form der Biegestruktur 40 aus einem flächigen Halbzeug durch spanabhebende Bearbeitung oder Stanzen hergestellt werden. Die beanspruchte Kühlvorrichtung 30 ist somit in einfacher und wirtschaftlicher Weise herstellbar. Die Kühlvorrichtung 30 nach FIG 1 stellt insgesamt im Wesentlichen eine wiederholt biegbare planare Heatpipe dar. Die Kühlvorrichtung 30 ist dazu geeignet, in einem nicht näher gezeigten Umrichter 50 eingesetzt zu werden, der winkelig aufgebaut ist. Ebenso ist die Kühlvorrichtung 30 zur Verwendung in einem nicht näher gezeigten faltbaren Elektronikgerät 60 eingesetzt zu werden. Zur Kühlvorrichtung 30 liegt ein Simulationsprogrammprodukt 70 vor, das dazu ausgebildet ist, ein Betriebsverhalten der Kühlvorrichtung 30 nachzustellen. Zum Betriebsverhalten kann ein mechanisches Verhalten, insbesondere eine mechanische Belastung von Längsstegen 44 und/oder Querstegen 46 der Biegestruktur 40, ein Verdampfungsverhalten, ein Fließverhalten und/oder Kondensationsverhalten des Kühlfluids 25 umfassen. Abhängig vom vorliegenden Biegezustand und ihrer räumlichen Lage ist die Kühlvorrichtung 30 im ungebogenen Zustand simulierbar. Die Einwirkung der Schwerkraft auf das Kühlfluid 25 ist als veränderliches Vektorfeld entlang des ersten Abschnitts 10, des zweiten Abschnitts 20 und/oder der Biegestruktur 40 darstellbar. Dies erlaubt eine vereinfachte Simulation mit reduziertem Rechenaufwand. Das Simulationsprogrammprodukt ist als sogenannter Digitaler Zwilling der Kühlvorrichtung 30 ausgebildet.

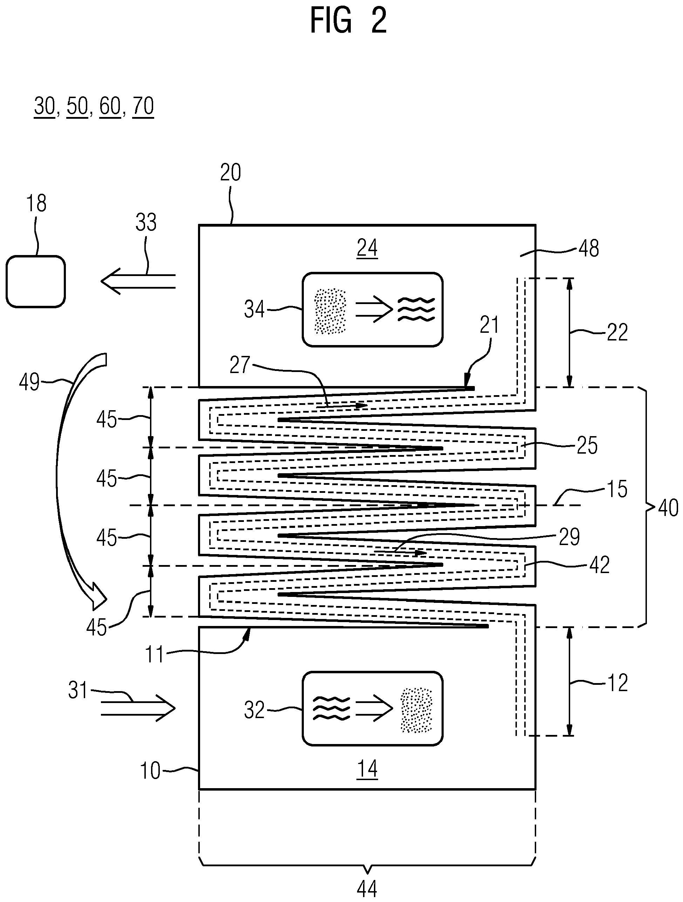

Eine zweite Ausführungsform der beanspruchten Kühlvorrichtung 30, die einen ersten Abschnitt 10 und einen zweiten Abschnitt 20 umfasst, die über eine Biegestruktur 40 miteinander verbunden sind, ist in FIG 2 in einer Draufsicht gezeigt. Der erste und zweite Abschnitt 10, 20 sind im Wesentlichen plattenförmig ausgebildet und weisen im Wesentlichen die gleiche Dicke auf. Die Kühlvorrichtung 10 ist in FIG 2 in einem ungebogenen Zustand dargestellt. Die Biegestruktur 40 ist einstückig mit dem ersten und zweiten Abschnitt 10, 20 ausgebildet und im ungebogenen Zustand auch im Wesentlichen plattenförmig. Der erste Abschnitt 10, der zweite Abschnitt 20 und die Biegestruktur 40 sind aus einem Werkstoff hergestellt, der zumindest teilweise aus Kunstharz 48 besteht. Die Biegestruktur 40 weist ebenso die im Wesentlichen gleiche Dicke wie der erste und zweite Abschnitt 10, 20 auf. Der erste Abschnitt 10 ist dazu geeignet, einen Wärmeeintrag 31 aufzunehmen und dadurch ein Kühlfluid 25 zu verdampfen. Eine solche Verdampfung 32 des Kühlfluids 25 ist in FIG 2 schematisch dargestellt. Der erste Abschnitt 10 ist zumindest teilweise als Hohlkörper ausgebildet, so dass der erste Abschnitt 10 ein Reservoir 14 für das Kühlfluid 25 bildet. Ebenso ist im ersten Abschnitt 10 ein Kanal 12 ausgebildet, durch den Kühlfluid 25 leitbar ist. Der Kanal 12 ist im Inneren des ersten Abschnitts 10 ausgebildet und ist hydraulisch mit einem Kanal 42 in der Biegestruktur 40 verbunden. Der Kanal 42 in der Biegestruktur 40 wiederum ist hydraulisch mit einem zweiten Kanal 22 im zweiten Abschnitt 20 hydraulisch verbunden. Hierdurch liegt insgesamt eine hydraulische Verbindung zwischen dem ersten und zweiten Abschnitt 10, 20, bzw. zwischen deren Kanälen 12, 22 vor. Der zweite Abschnitt 20 ist ebenso zumindest teilweise als Hohlkörper ausgebildet und bildet auch ein Reservoir 24 für das Kühlfluid 25. Der zweite Abschnitt 20 ist dazu ausgebildet, Wärme über eine Wärmeabfuhr 33 an eine nur schematisch gezeigte Wärmesenke 18 abzugeben. Der zweite Abschnitt 20 ist dazu ausgebildet, dampfförmiges Kühlfluid 25 zu kondensieren. Eine derartige Kondensation 34 ist in FIG 2 korrespondierend zur Verdampfung 32 schematisch gezeigt.

Die Biegestruktur 40 ist mehrfach Z-förmig ausgebildet und umfasst eine Mehrzahl an Z-Stegen 45, die im gezeigten ungebogenen Zustand sich im Wesentlichen diagonal zu einer Biegeachse 15 erstrecken, um die die Biegestruktur 40 wiederholt biegbar ist. In einem gebogenen Zustand wiederum erstrecken sich die Z-Stege 45 windschief zur Biegeachse 15. Die Biegeachse 15 ist im Wesentlichen parallel zu einer Kante 11, 21 des ersten und zweiten Abschnitts 10, 20 ausgerichtet. Die Z-Stege 45 sind unmittelbar miteinander verbunden, so dass die mehrfache Z-Form der Biegestruktur 40 ausgebildet ist. Insbesondere wird durch die mehrfache Z-Form mechanisch im Wesentlichen das Prinzip eines Balgs verwirklicht. Der Kanal 42 der Biegestruktur 40 erstreckt sich durch die Z-Stege 45. Innerhalb des Kanals 42 der Biegestruktur 40 liegt für verdampftes Kühlfluid 25 eine erste Fließrichtung 27 vor und für kondensiertes Kühlfluid 25 eine entgegengesetzte zweite Fließrichtung 29. Dadurch und in Verbindung mit dem im Wesentlichen plattenförmigen ersten und zweiten Abschnitt bildet die Kühlvorrichtung 30 eine planare Zweiphasenkühlung, also eine Heatpipe oder einen planaren Thermosiphon. Die Z-Form der Biegestruktur 40 macht diese um die Biegeachse 15 wiederholt biegbar. Eine entsprechende Biegung ist in FIG 2 als Pfeil 49 versinnbildlicht. Die Biegestruktur 40 übt in einem gebogenen Zustand eine Rückstellkraft aus, durch die die Kühlvorrichtung 30 in den gezeigten ungebogenen Zustand zurückstrebt. Auch bei einem Biegen 49 um die Biegeachse um 90° oder mehr liegen in der Biegestruktur 40 überwiegend, bevorzugt ausschließlich, elastische Verformungen vor. Die Kühlvorrichtung 30 ist auch so weit wiederholt um die Biegeachse 15 biegbar, dass sich Oberflächen des ersten und zweiten Abschnitts 10, 20 gegenüberliegen. Durch die Form der Biegestruktur 40 ist eine Plastifizierung und/oder Rissbildung im Kunstharz 48 beim Biegen 49 minimiert, so dass die Biegestruktur 40 dazu geeignet ist, einer erhöhten Zahl an Biegezyklen standzuhalten. Die Biegestruktur 40 mit dem darin ausgebildeten Kanal 42 ist beispielsweise durch additive Fertigung herstellbar. Alternativ oder ergänzend kann die Form der Biegestruktur 40 aus einem flächigen Halbzeug durch spanabhebende Bearbeitung oder Stanzen hergestellt werden. Die beanspruchte Kühlvorrichtung 30 ist somit in einfacher und wirtschaftlicher Weise herstellbar. Die Kühlvorrichtung 30 nach FIG 2 stellt insgesamt im Wesentlichen eine wiederholt biegbare planare Zweiphasenkühlung dar. Die Kühlvorrichtung 30 ist dazu geeignet, in einem nicht näher gezeigten Umrichter 50 eingesetzt zu werden, der winkelig aufgebaut ist. Ebenso ist die Kühlvorrichtung 30 zur Verwendung in einem nicht näher gezeigten faltbaren Elektronikgerät 60 eingesetzt zu werden. Zur Kühlvorrichtung 30 liegt ein Simulationsprogrammprodukt 70 vor, das dazu ausgebildet ist, ein Betriebsverhalten der Kühlvorrichtung 30 nachzustellen. Zum Betriebsverhalten kann ein mechanisches Verhalten, insbesondere eine mechanische Belastung der Z-Stege 45 und/oder in einem Verbindungsbereich der einzelnen Z-Stege 45 der Biegestruktur 40, ein Verdampfungsverhalten, ein Fließverhalten und/oder Kondensationsverhalten des Kühlfluids 25 umfassen. Abhängig vom vorliegenden Biegezustand und ihrer räumlichen Lage ist die Kühlvorrichtung 30 im ungebogenen Zustand simulierbar. Die Einwirkung der Schwerkraft auf das Kühlfluid 25 ist als veränderliches Vektorfeld entlang des ersten Abschnitts 10, des zweiten Abschnitts 20 und/oder der Biegestruktur 40 darstellbar. Dies erlaubt eine vereinfachte Simulation mit reduziertem Rechenaufwand. Das Simulationsprogrammprodukt ist als sogenannter Digitaler Zwilling der Kühlvorrichtung 30 ausgebildet.

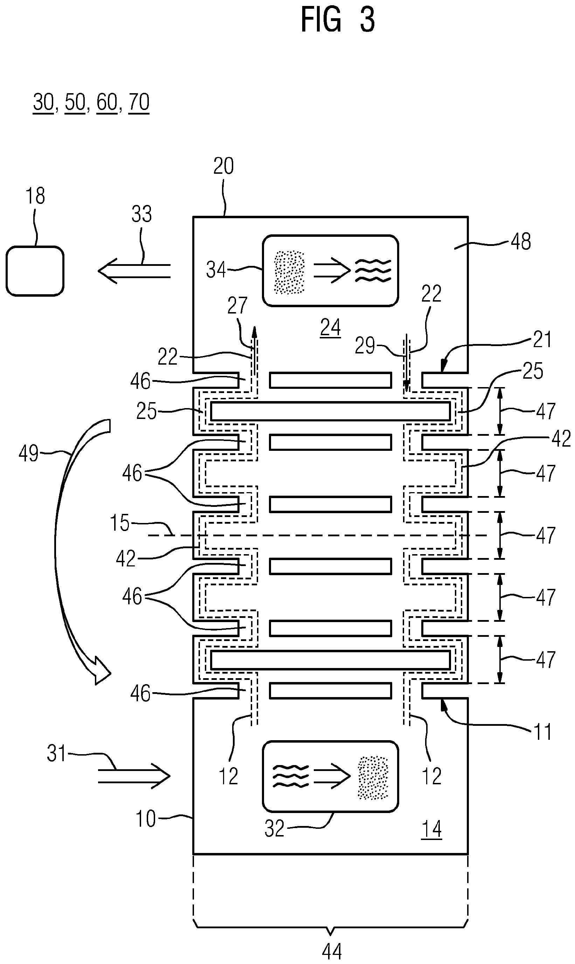

Eine dritte Ausführungsform der beanspruchten Kühlvorrichtung 30, die einen ersten Abschnitt 10 und einen zweiten Abschnitt 20 umfasst, die über eine Biegestruktur 40 miteinander verbunden sind, ist in FIG 3 in einer Draufsicht gezeigt. Der erste und zweite Abschnitt 10, 20 sind im Wesentlichen plattenförmig ausgebildet und weisen im Wesentlichen die gleiche Dicke auf. Die Kühlvorrichtung 10 ist in FIG 3 in einem ungebogenen Zustand dargestellt. Die Biegestruktur 40 ist einstückig mit dem ersten und zweiten Abschnitt 10, 20 ausgebildet und im ungebogenen Zustand auch im Wesentlichen plattenförmig. Der erste Abschnitt 10, der zweite Abschnitt 20 und die Biegestruktur 40 sind aus einem Werkstoff hergestellt, der zumindest teilweise aus Kunstharz 48 besteht. Die Biegestruktur 40 weist ebenso die im Wesentlichen gleiche Dicke wie der erste und zweite Abschnitt 10, 20 auf. Der erste Abschnitt 10 ist dazu geeignet, einen Wärmeeintrag 31 aufzunehmen und dadurch ein Kühlfluid 25 zu verdampfen. Eine solche Verdampfung 32 des Kühlfluids 25 ist in FIG 3 schematisch dargestellt. Der erste Abschnitt 10 ist zumindest teilweise als Hohlkörper ausgebildet, so dass der erste Abschnitt 10 ein Reservoir 14 für das Kühlfluid 25 bildet. Ebenso sind im ersten Abschnitt 10 ein Kanäle 12 ausgebildet, durch die Kühlfluid 25 leitbar ist. Die Kanäle 12 sind im Inneren des ersten Abschnitts 10 ausgebildet und sind jeweils hydraulisch mit einem Kanal 42 in der Biegestruktur 40 verbunden. Die Kanäle 42 in der Biegestruktur 40 wiederum sind hydraulisch mit zweiten Kanälen 22 im zweiten Abschnitt 20 hydraulisch verbunden. Hierdurch liegt insgesamt jeweils eine hydraulische Verbindung zwischen dem ersten und zweiten Abschnitt 10, 20, bzw. zwischen deren entsprechenden Kanälen 12, 22 vor. Über die Reservoir 14, 14 im ersten bzw. zweiten Abschnitt 10, 20 sind auch die ersten und zweiten Kanäle 12, 22 untereinander hydraulisch verbunden. Der zweite Abschnitt 20 ist ebenso zumindest teilweise als Hohlkörper ausgebildet und bildet auch ein Reservoir 24 für das Kühlfluid 25. Der zweite Abschnitt 20 ist dazu ausgebildet, Wärme über eine Wärmeabfuhr 33 an eine nur schematisch gezeigte Wärmesenke 18 abzugeben. Der zweite Abschnitt 20 ist dazu ausgebildet, dampfförmiges Kühlfluid 25 zu kondensieren. Eine derartige Kondensation 34 ist in FIG 3 korrespondierend zur Verdampfung 32 schematisch gezeigt.

Die Biegestruktur 40 weist eine Mehrzahl an umlaufenden Strukturen 47 auf, die im Wesentlichen als rechteckige Rahmen ausgebildet sind. Dadurch weisen die umlaufenden Strukturen 47, im Vergleich mit ansonsten gleich dimensionierten offenen Strukturen wie in FIG 1 oder FIG 2 eine erhöhte Biegesteifigkeit um die Biegeachse 15 auf. Die umlaufenden Strukturen 47 sind im gezeigten ungebogenen Zustand entlang ihrer jeweils langen Seite, im Wesentlichen parallel zu einer Kante 11, 21 des ersten bzw. zweiten Abschnitts 10, 20 ausgerichtet. Diese bleiben auch bei einem Biegen 49 um die Biegeachse 15 im Wesentlichen parallel zur Kante 11, 21 des ersten bzw. zweiten Abschnitts 10, 20. Die umlaufenden Strukturen 47 und untereinander über Querstege 46 miteinander verbunden, durch die sich auch die Kanäle 42 in der Biegestruktur 40 erstrecken. Durch die umlaufenden Strukturen 47 ist die die Biegestruktur 40 wiederholt biegbar. Die Biegeachse 15 ist dabei im Wesentlichen parallel zu einer Kante 11, 21 des ersten und zweiten Abschnitts 10, 20 ausgerichtet. Dier Kanäle 42 der Biegestruktur 40 erstrecken sich durch die umlaufenden Strukturen 47 und Querstege 46. Innerhalb eines Kanals 42 der Biegestruktur 40 liegt für verdampftes Kühlfluid 25 eine erste Fließrichtung 27 vor. In einem anderen Kanal 42 liegt für kondensiertes Kühlfluid 25 eine entgegengesetzte zweite Fließrichtung 29 vor. Dadurch wird in der Biegestruktur 40 ein Umlaufen des Kühlfluids 25 hervorgerufen. In Verbindung mit dem im Wesentlichen plattenförmigen ersten und zweiten Abschnitt bildet die Kühlvorrichtung 30 eine planare Zweiphasenkühlung, also eine planare Heatpipe oder einen planaren Thermosiphon. Die mehrfachen verbundenen umlaufenden Strukturen 47 in der Biegestruktur 40 machen diese um die Biegeachse 15 wiederholt biegbar. Auch durch diese Form wird mechanisch im Wesentlichen das Prinzip eines Balgs verwirklicht. Eine entsprechende Biegung ist in FIG 3 als Pfeil 49 versinnbildlicht. Die Biegestruktur 40 übt in einem gebogenen Zustand eine Rückstellkraft aus, durch die die Kühlvorrichtung 30 in den gezeigten ungebogenen Zustand zurückstrebt. Auch bei einem Biegen 49 um die Biegeachse um 90° oder mehr liegen in der Biegestruktur 40 überwiegend, bevorzugt ausschließlich, elastische Verformungen vor. Die Kühlvorrichtung 30 ist auch so weit wiederholt um die Biegeachse 15 biegbar, dass sich Oberflächen des ersten und zweiten Abschnitts 10, 20 gegenüberliegen. Durch die Form der Biegestruktur 40 ist eine Plastifizierung und/oder Rissbildung im Kunstharz 48 beim Biegen 49 minimiert, so dass die Biegestruktur 40 dazu geeignet ist, einer erhöhten Zahl an Biegezyklen standzuhalten. Die Biegestruktur 40 mit den darin ausgebildeten Kanälen 42 ist beispielsweise durch additive Fertigung herstellbar. Alternativ oder ergänzend kann die Form der Biegestruktur 40 aus einem flächigen Halbzeug durch spanabhebende Bearbeitung oder Stanzen hergestellt werden. Die beanspruchte Kühlvorrichtung 30 ist somit in einfacher und wirtschaftlicher Weise herstellbar. Die Kühlvorrichtung 30 nach FIG 3 stellt insgesamt im Wesentlichen eine wiederholt biegbare planare Zweiphasenkühlung dar. Die Kühlvorrichtung 30 ist dazu geeignet, in einem nicht näher gezeigten Umrichter 50 eingesetzt zu werden, der winkelig aufgebaut ist. Ebenso ist die Kühlvorrichtung 30 zur Verwendung in einem nicht näher gezeigten faltbaren Elektronikgerät 60 eingesetzt zu werden. Zur Kühlvorrichtung 30 liegt ein Simulationsprogrammprodukt 70 vor, das dazu ausgebildet ist, ein Betriebsverhalten der Kühlvorrichtung 30 nachzustellen. Zum Betriebsverhalten kann ein mechanisches Verhalten, insbesondere eine mechanische Belastung umlaufenden Strukturen 47 und/oder Querstegen 46 der Biegestruktur 40, ein Verdampfungsverhalten, ein Fließverhalten und/oder Kondensationsverhalten des Kühlfluids 25 umfassen. Abhängig vom vorliegenden Biegezustand und ihrer räumlichen Lage ist die Kühlvorrichtung 30 im ungebogenen Zustand simulierbar. Die Einwirkung der Schwerkraft auf das Kühlfluid 25 ist als veränderliches Vektorfeld entlang des ersten Abschnitts 10, des zweiten Abschnitts 20 und/oder der Biegestruktur 40 darstellbar. Dies erlaubt eine vereinfachte Simulation mit reduziertem Rechenaufwand. Das Simulationsprogrammprodukt ist als sogenannter Digitaler Zwilling der Kühlvorrichtung 30 ausgebildet.

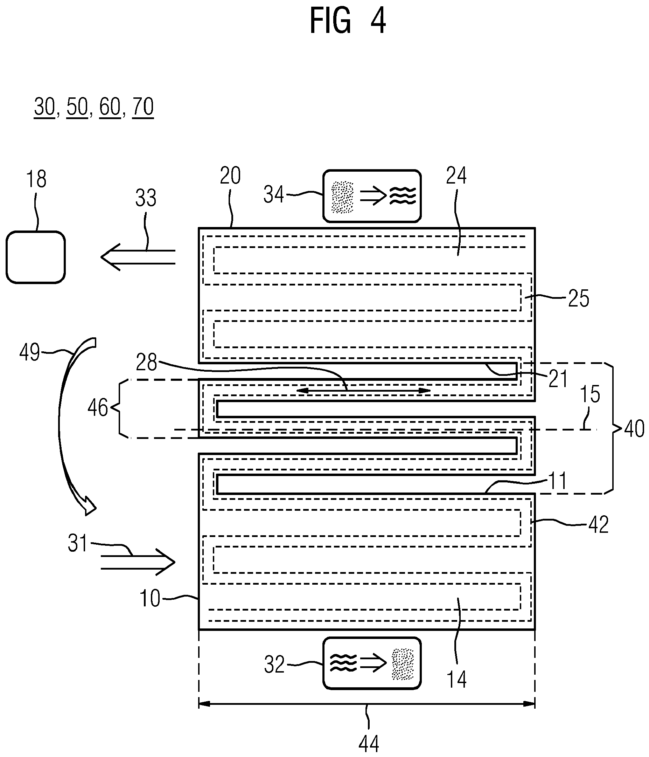

Eine vierte Ausführungsform der beanspruchten Kühlvorrichtung 30, die einen ersten Abschnitt 10 und einen zweiten Abschnitt 20 umfasst, die über eine Biegestruktur 40 miteinander verbunden sind, ist in FIG 4 in einer Draufsicht gezeigt. Der erste und zweite Abschnitt 10, 20 sind im Wesentlichen plattenförmig ausgebildet und weisen im Wesentlichen die gleiche Dicke auf. Die Kühlvorrichtung 10 ist in FIG 4 in einem ungebogenen Zustand dargestellt. Die Biegestruktur 40 ist einstückig mit dem ersten und zweiten Abschnitt 10, 20 ausgebildet und im ungebogenen Zustand auch im Wesentlichen plattenförmig. Der erste Abschnitt 10, der zweite Abschnitt 20 und die Biegestruktur 40 sind aus einem Werkstoff hergestellt, der zumindest teilweise aus Kunstharz 48 besteht. Die Biegestruktur 40 weist ebenso die im Wesentlichen gleiche Dicke wie der erste und zweite Abschnitt 10, 20 auf. Der erste Abschnitt 10 ist dazu geeignet, einen Wärmeeintrag 31 aufzunehmen und dadurch ein Kühlfluid 25 zu verdampfen. Eine solche Verdampfung 32 des Kühlfluids 25 ist in FIG 4 schematisch dargestellt. Der erste Abschnitt 10 ist zumindest teilweise als Hohlkörper ausgebildet, so dass der erste Abschnitt 10 ein Reservoir 14 für das Kühlfluid 25 bildet. Ebenso ist im ersten Abschnitt 10 ein erster Kanal 12 ausgebildet, durch den Kühlfluid 25 leitbar ist und der im ersten Abschnitt 10 endet. Der erste Kanal 12 ist im Inneren des ersten Abschnitts 10 ausgebildet und ist hydraulisch mit einem Kanal 42 in der Biegestruktur 40 verbunden. Der Kanal 42 in der Biegestruktur 40 wiederum ist hydraulisch mit einem zweiten Kanal 22 im zweiten Abschnitt 20 hydraulisch verbunden. Hierdurch liegt insgesamt eine hydraulische Verbindung zwischen dem ersten und zweiten Abschnitt 10, 20, bzw. zwischen deren Kanälen 12, 22 vor. Der zweite Abschnitt 20 ist ebenso zumindest teilweise als Hohlkörper ausgebildet und bildet auch ein Reservoir 24 für das Kühlfluid 25, wobei der zweite Kanal 22 im zweiten Abschnitt 20 endet. Der zweite Abschnitt 20 ist dazu ausgebildet, Wärme über eine Wärmeabfuhr 33 an eine nur schematisch gezeigte Wärmesenke 18 abzugeben. Der zweite Abschnitt 20 ist dazu ausgebildet, dampfförmiges Kühlfluid 25 zu kondensieren. Eine derartige Kondensation 34 ist in FIG 4 korrespondierend zur Verdampfung 32 schematisch gezeigt.

Die Biegestruktur 40 ist mäanderförmig ausgebildet und umfasst eine Mehrzahl an Längsstegen 44, die sich im Wesentlichen parallel zu einer Biegeachse 15 erstrecken, um die die Biegestruktur 40 wiederholt biegbar ist. Die Biegeachse 15 ist dabei im Wesentlichen parallel zu einer Kante 11, 21 des ersten und zweiten Abschnitts 10, 20 ausgerichtet. Die Längsstege 44 sind über Querstege 46 miteinander verbunden, so dass die Mäanderform der Biegestruktur 40 ausgebildet ist. Der Kanal 42 der Biegestruktur 40 erstreckt sich durch die Längsstege 44 und Querstege 46. Innerhalb des Kanals 42 der Biegestruktur 40 liegt für verdampftes und flüssiges, also kondensiertes, Kühlfluid 25 eine alternierende Fließrichtung 28 vor. Durch eine derartige alternierende Fließrichtung 28 von verdampftem und kondensiertem Kühlfluid 25 erfolgt ein Wärmetransport vom ersten zum zweiten Abschnitt 10, 20. Dadurch und in Verbindung mit dem im Wesentlichen plattenförmigen ersten und zweiten Abschnitt 10, 20 bildet die Kühlvorrichtung 30 eine planare Zweiphasenkühlung, insbesondere eine eine planare pulsierende Heatpipe. Die Mäanderform der Biegestruktur 40 macht diese um die Biegeachse 15 wiederholt biegbar. Insbesondere wird durch die Mäanderform mechanisch im Wesentlichen das Prinzip eines Balgs verwirklicht. Eine entsprechende Biegung ist in FIG 4 als Pfeil 49 versinnbildlicht. Die Biegestruktur 40 übt in einem gebogenen Zustand eine Rückstellkraft aus, durch die die Kühlvorrichtung 30 in den gezeigten ungebogenen Zustand zurückstrebt. Auch bei einem Biegen 49 um die Biegeachse um 90° oder mehr liegen in der Biegestruktur 40 überwiegend, bevorzugt ausschließlich, elastische Verformungen vor. Die Kühlvorrichtung 30 ist auch so weit wiederholt um die Biegeachse 15 biegbar, dass sich Oberflächen des ersten und zweiten Abschnitts 10, 20 gegenüberliegen. Durch die Form der Biegestruktur 40 ist eine Plastifizierung und/oder Rissbildung im Kunstharz 48 beim Biegen 49 minimiert, so dass die Biegestruktur 40 dazu geeignet ist, einer erhöhten Zahl an Biegezyklen standzuhalten. Die Biegestruktur 40 mit dem darin ausgebildeten Kanal 42 ist beispielsweise durch additive Fertigung herstellbar. Alternativ oder ergänzend kann die Form der Biegestruktur 40 aus einem flächigen Halbzeug durch spanabhebende Bearbeitung oder Stanzen hergestellt werden. Die beanspruchte Kühlvorrichtung 30 ist somit in einfacher und wirtschaftlicher Weise herstellbar. Die Kühlvorrichtung 30 nach FIG 4 stellt insgesamt im Wesentlichen eine wiederholt biegbare planare Heatpipe dar. Die Kühlvorrichtung 30 ist dazu geeignet, in einem nicht näher gezeigten Umrichter 50 eingesetzt zu werden, der winkelig aufgebaut ist. Ebenso ist die Kühlvorrichtung 30 zur Verwendung in einem nicht näher gezeigten faltbaren Elektronikgerät 60 eingesetzt zu werden. Zur Kühlvorrichtung 30 liegt ein Simulationsprogrammprodukt 70 vor, das dazu ausgebildet ist, ein Betriebsverhalten der Kühlvorrichtung 30 nachzustellen. Zum Betriebsverhalten kann ein mechanisches Verhalten, insbesondere eine mechanische Belastung von Längsstegen 44 und/oder Querstegen 46 der Biegestruktur 40, ein Verdampfungsverhalten, ein Fließverhalten und/oder Kondensationsverhalten des Kühlfluids 25 umfassen. Abhängig vom vorliegenden Biegezustand und ihrer räumlichen Lage ist die Kühlvorrichtung 30 im ungebogenen Zustand simulierbar. Die Einwirkung der Schwerkraft auf das Kühlfluid 25 ist als veränderliches Vektorfeld entlang des ersten Abschnitts 10, des zweiten Abschnitts 20 und/oder der Biegestruktur 40 darstellbar. Dies erlaubt eine vereinfachte Simulation mit reduziertem Rechenaufwand. Das Simulationsprogrammprodukt ist als sogenannter Digitaler Zwilling der Kühlvorrichtung 30 ausgebildet.

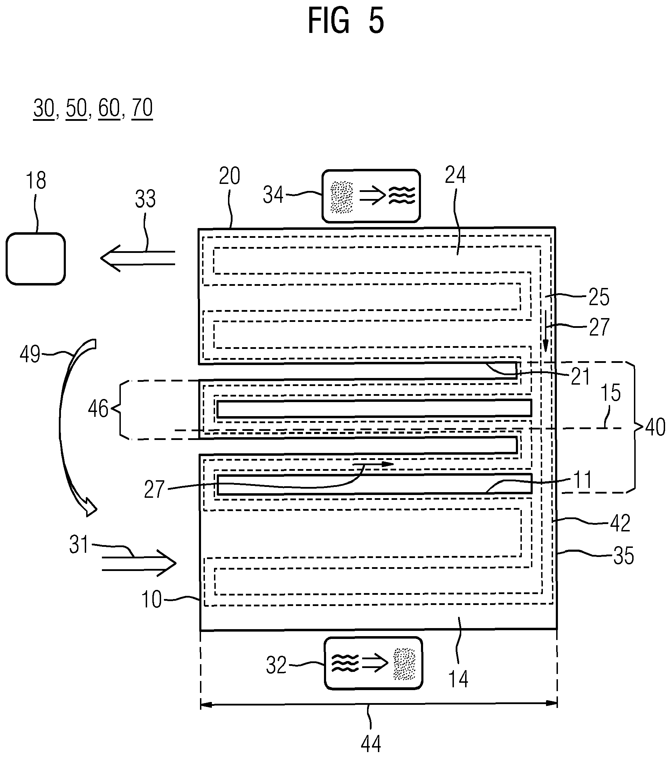

Eine fünfte Ausführungsform der beanspruchten Kühlvorrichtung 30, die einen ersten Abschnitt 10 und einen zweiten Abschnitt 20 umfasst, die über eine Biegestruktur 40 miteinander verbunden sind, ist in FIG 5 in einer Draufsicht gezeigt. Der erste und zweite Abschnitt 10, 20 sind im Wesentlichen plattenförmig ausgebildet und weisen im Wesentlichen die gleiche Dicke auf. Die Kühlvorrichtung 10 ist in FIG 5 in einem ungebogenen Zustand dargestellt. Die Biegestruktur 40 ist einstückig mit dem ersten und zweiten Abschnitt 10, 20 ausgebildet und im ungebogenen Zustand auch im Wesentlichen plattenförmig. Der erste Abschnitt 10, der zweite Abschnitt 20 und die Biegestruktur 40 sind aus einem Werkstoff hergestellt, der zumindest teilweise aus Kunstharz 48 besteht. Die Biegestruktur 40 weist ebenso die im Wesentlichen gleiche Dicke wie der erste und zweite Abschnitt 10, 20 auf. Der erste Abschnitt 10 ist dazu geeignet, einen Wärmeeintrag 31 aufzunehmen und dadurch ein Kühlfluid 25 zu verdampfen. Eine solche Verdampfung 32 des Kühlfluids 25 ist in FIG 5 schematisch dargestellt. Der erste Abschnitt 10 ist zumindest teilweise als Hohlkörper ausgebildet, so dass der erste Abschnitt 10 ein Reservoir 14 für das Kühlfluid 25 bildet. Ebenso ist im ersten Abschnitt 10 ein erster Kanal 12 ausgebildet, durch den Kühlfluid 25 leitbar ist. Der erste Kanal 12 ist im Inneren des ersten Abschnitts 10 ausgebildet und ist hydraulisch mit einem Kanal 42 in der Biegestruktur 40 verbunden. Der Kanal 42 in der Biegestruktur 40 wiederum ist hydraulisch mit einem zweiten Kanal 22 im zweiten Abschnitt 20 hydraulisch verbunden. Hierdurch liegt insgesamt eine hydraulische Verbindung zwischen dem ersten und zweiten Abschnitt 10, 20, bzw. zwischen deren Kanälen 12, 22 vor. Der zweite Abschnitt 20 ist ebenso zumindest teilweise als Hohlkörper ausgebildet und bildet auch ein Reservoir 24 für das Kühlfluid 25. Der zweite Abschnitt 20 ist dazu ausgebildet, Wärme über eine Wärmeabfuhr 33 an eine nur schematisch gezeigte Wärmesenke 18 abzugeben. Der zweite Abschnitt 20 ist dazu ausgebildet, dampfförmiges Kühlfluid 25 zu kondensieren. Eine derartige Kondensation 34 ist in FIG 5 korrespondierend zur Verdampfung 32 schematisch gezeigt.

Die Biegestruktur 40 ist mäanderförmig ausgebildet und umfasst eine Mehrzahl an Längsstegen 44, die sich im Wesentlichen parallel zu einer Biegeachse 15 erstrecken, um die die Biegestruktur 40 wiederholt biegbar ist. Die Biegeachse 15 ist dabei im Wesentlichen parallel zu einer Kante 11, 21 des ersten und zweiten Abschnitts 10, 20 ausgerichtet. Die Längsstege 44 sind über Querstege 46 miteinander verbunden, so dass die Mäanderform der Biegestruktur 40 ausgebildet ist. Der Kanal 42 der Biegestruktur 40 erstreckt sich durch die Längsstege 44 und Querstege 46. Weiter erstreckt sich der Kanal 42 durch einen Rückführabschnitt 35. Durch den Rückführabschnitt 35 sind der erste und zweite Abschnitt 10, 20 miteinander verbunden. Innerhalb des Kanals 42 der Biegestruktur 40 liegt für verdampftes und flüssiges, also kondensiertes, Kühlfluid 25 eine erste Fließrichtung 27 vor, durch die das Kühlfluid 25 in der Biegestruktur 40 zirkuliert. Dadurch und in Verbindung mit dem im Wesentlichen plattenförmigen ersten und zweiten Abschnitt bildet die Kühlvorrichtung 30 eine planare Zweiphasenkühlung, also eine planare schlaufenförmige Heatpipe, auch CLosed-Loop-Heatpipe genannt. Die Mäanderform der Biegestruktur 40 macht diese um die Biegeachse 15 wiederholt biegbar. Insbesondere wird durch die Mäanderform mechanisch im Wesentlichen das Prinzip eines Balgs verwirklicht. Eine entsprechende Biegung ist in FIG 5 als Pfeil 49 versinnbildlicht. Die Biegestruktur 40 übt in einem gebogenen Zustand eine Rückstellkraft aus, durch die die Kühlvorrichtung 30 in den gezeigten ungebogenen Zustand zurückstrebt. Auch bei einem Biegen 49 um die Biegeachse um 90° oder mehr liegen in der Biegestruktur 40 überwiegend, bevorzugt ausschließlich, elastische Verformungen vor. Die Kühlvorrichtung 30 ist auch so weit wiederholt um die Biegeachse 15 biegbar, dass sich Oberflächen des ersten und zweiten Abschnitts 10, 20 gegenüberliegen. Durch die Form der Biegestruktur 40 ist eine Plastifizierung und/oder Rissbildung im Kunstharz 48 beim Biegen 49 minimiert, so dass die Biegestruktur 40 dazu geeignet ist, einer erhöhten Zahl an Biegezyklen standzuhalten. Die Biegestruktur 40 mit dem darin ausgebildeten Kanal 42 ist beispielsweise durch additive Fertigung herstellbar. Alternativ oder ergänzend kann die Form der Biegestruktur 40 aus einem flächigen Halbzeug durch spanabhebende Bearbeitung oder Stanzen hergestellt werden. Die beanspruchte Kühlvorrichtung 30 ist somit in einfacher und wirtschaftlicher Weise herstellbar. Die Kühlvorrichtung 30 nach FIG 5 stellt insgesamt im Wesentlichen eine wiederholt biegbare planare Heatpipe dar. Die Kühlvorrichtung 30 ist dazu geeignet, in einem nicht näher gezeigten Umrichter 50 eingesetzt zu werden, der winkelig aufgebaut ist. Ebenso ist die Kühlvorrichtung 30 zur Verwendung in einem nicht näher gezeigten faltbaren Elektronikgerät 60 eingesetzt zu werden. Zur Kühlvorrichtung 30 liegt ein Simulationsprogrammprodukt 70 vor, das dazu ausgebildet ist, ein Betriebsverhalten der Kühlvorrichtung 30 nachzustellen. Zum Betriebsverhalten kann ein mechanisches Verhalten, insbesondere eine mechanische Belastung von Längsstegen 44 und/oder Querstegen 46 der Biegestruktur 40, ein Verdampfungsverhalten, ein Fließverhalten und/oder Kondensationsverhalten des Kühlfluids 25 umfassen. Abhängig vom vorliegenden Biegezustand und ihrer räumlichen Lage ist die Kühlvorrichtung 30 im ungebogenen Zustand simulierbar. Die Einwirkung der Schwerkraft auf das Kühlfluid 25 ist als veränderliches Vektorfeld entlang des ersten Abschnitts 10, des zweiten Abschnitts 20 und/oder der Biegestruktur 40 darstellbar. Dies erlaubt eine vereinfachte Simulation mit reduziertem Rechenaufwand. Das Simulationsprogrammprodukt ist als sogenannter Digitaler Zwilling der Kühlvorrichtung 30 ausgebildet.

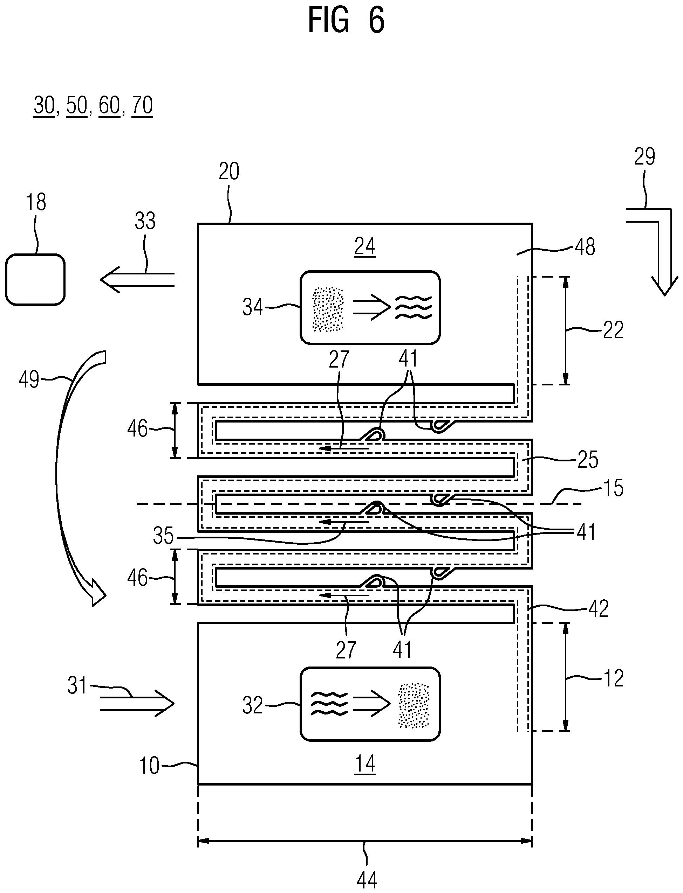

Eine sechste Ausführungsform der beanspruchten Kühlvorrichtung 30, die einen ersten Abschnitt 10 und einen zweiten Abschnitt 20 umfasst, die über eine Biegestruktur 40 miteinander verbunden sind, ist in FIG 6 in einer Draufsicht gezeigt. Der erste und zweite Abschnitt 10, 20 sind im Wesentlichen plattenförmig ausgebildet und weisen im Wesentlichen die gleiche Dicke auf. Die Kühlvorrichtung 10 ist in FIG 6 in einem ungebogenen Zustand dargestellt. Die Biegestruktur 40 ist einstückig mit dem ersten und zweiten Abschnitt 10, 20 ausgebildet und im ungebogenen Zustand auch im Wesentlichen plattenförmig. Der erste Abschnitt 10, der zweite Abschnitt 20 und die Biegestruktur 40 sind aus einem Werkstoff hergestellt, der zumindest teilweise aus Kunstharz 48 besteht. Die Biegestruktur 40 weist ebenso die im Wesentlichen gleiche Dicke wie der erste und zweite Abschnitt 10, 20 auf. Der erste Abschnitt 10 ist dazu geeignet, einen Wärmeeintrag 31 aufzunehmen und dadurch ein Kühlfluid 25 zu verdampfen. Eine solche Verdampfung 32 des Kühlfluids 25 ist in FIG 6 schematisch dargestellt. Der erste Abschnitt 10 ist zumindest teilweise als Hohlkörper ausgebildet, so dass der erste Abschnitt 10 ein Reservoir 14 für das Kühlfluid 25 bildet. Ebenso ist im ersten Abschnitt 10 ein Kanal 12 ausgebildet, durch den Kühlfluid 25 leitbar ist. Der Kanal 12 ist im Inneren des ersten Abschnitts 10 ausgebildet und ist hydraulisch mit einem Kanal 42 in der Biegestruktur 40 verbunden. Der Kanal 42 in der Biegestruktur 40 wiederum ist hydraulisch mit einem zweiten Kanal 22 im zweiten Abschnitt 20 hydraulisch verbunden. Hierdurch liegt insgesamt eine hydraulische Verbindung zwischen dem ersten und zweiten Abschnitt 10, 20, bzw. zwischen deren Kanälen 12, 22 vor. Der zweite Abschnitt 20 ist ebenso zumindest teilweise als Hohlkörper ausgebildet und bildet auch ein Reservoir 24 für das Kühlfluid 25. Der zweite Abschnitt 20 ist dazu ausgebildet, Wärme über eine Wärmeabfuhr 33 an eine nur schematisch gezeigte Wärmesenke 18 abzugeben. Der zweite Abschnitt 20 ist dazu ausgebildet, dampfförmiges Kühlfluid 25 zu kondensieren. Eine derartige Kondensation 34 ist in FIG 6 korrespondierend zur Verdampfung 32 schematisch gezeigt.

Die Biegestruktur 40 ist mäanderförmig ausgebildet und umfasst eine Mehrzahl an Längsstegen 44, die sich im Wesentlichen parallel zu einer Biegeachse 15 erstrecken, um die die Biegestruktur 40 wiederholt biegbar ist. Die Biegeachse 15 ist dabei im Wesentlichen parallel zu einer Kante 11, 21 des ersten und zweiten Abschnitts 10, 20 ausgerichtet. Die Längsstege 44 sind über Querstege 46 miteinander verbunden, so dass die Mäanderform der Biegestruktur 40 ausgebildet ist. Der Kanal 42 der Biegestruktur 40 erstreckt sich durch die Längsstege 44 und Querstege 46. Einer Mehrzahl an Längsstegen 44 ist einstückig mit einem Teslaventil 41 ausgebildet, durch das dem strömenden Kühlfluid 25 im entsprechenden Längssteg 44 eine Vorzugsrichtung aufgeprägt wird. Hierdurch ist insbesondere für verdampftes Kühlfluid 25 die Strömungsrichtung unabhängig von einer vorliegenden Biegung und/oder räumlichen Lage der Kühlvorrichtung 30 dem Kühlfluid 25 eine Strömungsrichtung aufprägbar und so eine Funktionstüchtigkeit der Kühlvorrichtung 30 sichergestellt werden. Für eine Rückführung von kondensiertem Kühlfluid 25 kann der zweite Abschnitt 20 mit einer weiteren, nicht gezeigten Biegestruktur 40 verbunden sein. Die Teslaventile 41 sind frei von beweglichen Teilen und bieten dadurch eine erhöhte Zuverlässigkeit. Innerhalb des Kanals 42 der Biegestruktur 40 liegt für verdampftes Kühlfluid 25 eine erste Fließrichtung 27 vor und für kondensiertes Kühlfluid 25. Dadurch und in Verbindung mit dem im Wesentlichen plattenförmigen ersten und zweiten Abschnitt bildet die Kühlvorrichtung 30 eine planare Zweiphasenkühlung, also eine planare Heatpipe oder einen planaren Thermosiphon. Die Mäanderform der Biegestruktur 40 macht diese um die Biegeachse 15 wiederholt biegbar. Insbesondere wird durch die Mäanderform mechanisch im Wesentlichen das Prinzip eines Balgs verwirklicht. Eine entsprechende Biegung ist in FIG 6 als Pfeil 49 versinnbildlicht. Die Biegestruktur 40 übt in einem gebogenen Zustand eine Rückstellkraft aus, durch die die Kühlvorrichtung 30 in den gezeigten ungebogenen Zustand zurückstrebt. Auch bei einem Biegen 49 um die Biegeachse um 90° oder mehr liegen in der Biegestruktur 40 überwiegend, bevorzugt ausschließlich, elastische Verformungen vor. Die Kühlvorrichtung 30 ist auch so weit wiederholt um die Biegeachse 15 biegbar, dass sich Oberflächen des ersten und zweiten Abschnitts 10, 20 gegenüberliegen. Durch die Form der Biegestruktur 40 ist eine Plastifizierung und/oder Rissbildung im Kunstharz 48 beim Biegen 49 minimiert, so dass die Biegestruktur 40 dazu geeignet ist, einer erhöhten Zahl an Biegezyklen standzuhalten. Die Biegestruktur 40 mit dem darin ausgebildeten Kanal 42 ist beispielsweise durch additive Fertigung herstellbar. Alternativ oder ergänzend kann die Form der Biegestruktur 40 aus einem flächigen Halbzeug durch spanabhebende Bearbeitung oder Stanzen hergestellt werden. Die beanspruchte Kühlvorrichtung 30 ist somit in einfacher und wirtschaftlicher Weise herstellbar. Die Kühlvorrichtung 30 nach FIG 6 stellt insgesamt im Wesentlichen eine wiederholt biegbare planare Zweiphasenkühlung dar. Die Kühlvorrichtung 30 ist dazu geeignet, in einem nicht näher gezeigten Umrichter 50 eingesetzt zu werden, der winkelig aufgebaut ist. Ebenso ist die Kühlvorrichtung 30 zur Verwendung in einem nicht näher gezeigten faltbaren Elektronikgerät 60 eingesetzt zu werden. Zur Kühlvorrichtung 30 liegt ein Simulationsprogrammprodukt 70 vor, das dazu ausgebildet ist, ein Betriebsverhalten der Kühlvorrichtung 30 nachzustellen. Zum Betriebsverhalten kann ein mechanisches Verhalten, insbesondere eine mechanische Belastung von Längsstegen 44 und/oder Querstegen 46 der Biegestruktur 40, ein Verdampfungsverhalten, ein Fließverhalten und/oder Kondensationsverhalten des Kühlfluids 25 umfassen. Abhängig vom vorliegenden Biegezustand und ihrer räumlichen Lage ist die Kühlvorrichtung 30 im ungebogenen Zustand simulierbar. Die Einwirkung der Schwerkraft auf das Kühlfluid 25 ist als veränderliches Vektorfeld entlang des ersten Abschnitts 10, des zweiten Abschnitts 20 und/oder der Biegestruktur 40 darstellbar. Dies erlaubt eine vereinfachte Simulation mit reduziertem Rechenaufwand. Das Simulationsprogrammprodukt ist als sogenannter Digitaler Zwilling der Kühlvorrichtung 30 ausgebildet.

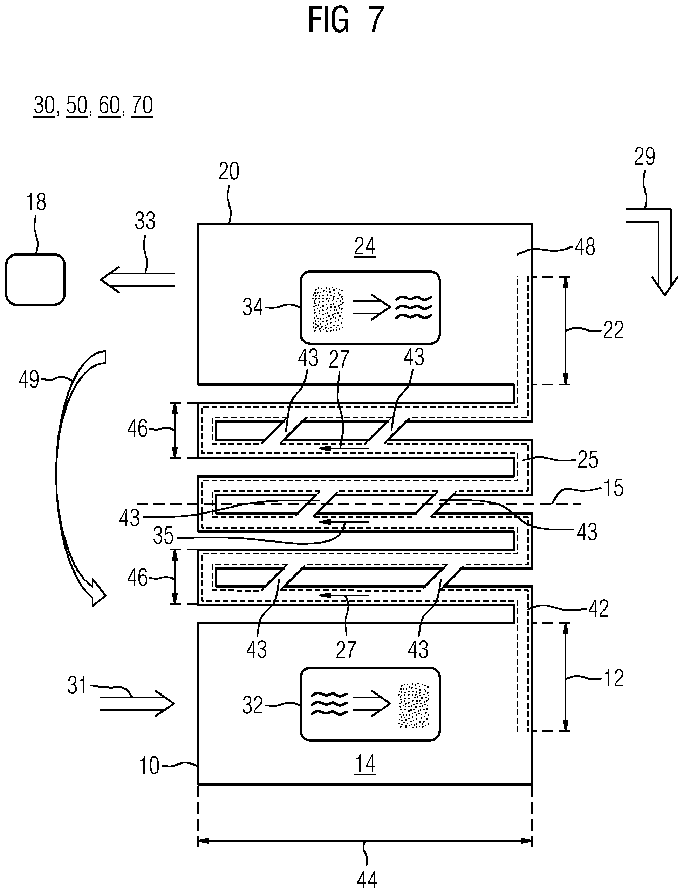

Eine siebente Ausführungsform der beanspruchten Kühlvorrichtung 30, die einen ersten Abschnitt 10 und einen zweiten Abschnitt 20 umfasst, die über eine Biegestruktur 40 miteinander verbunden sind, ist in FIG 7 in einer Draufsicht gezeigt. Der erste und zweite Abschnitt 10, 20 sind im Wesentlichen plattenförmig ausgebildet und weisen im Wesentlichen die gleiche Dicke auf. Die Kühlvorrichtung 10 ist in FIG 7 in einem ungebogenen Zustand dargestellt. Die Biegestruktur 40 ist einstückig mit dem ersten und zweiten Abschnitt 10, 20 ausgebildet und im ungebogenen Zustand auch im Wesentlichen plattenförmig. Der erste Abschnitt 10, der zweite Abschnitt 20 und die Biegestruktur 40 sind aus einem Werkstoff hergestellt, der zumindest teilweise aus Kunstharz 48 besteht. Die Biegestruktur 40 weist ebenso die im Wesentlichen gleiche Dicke wie der erste und zweite Abschnitt 10, 20 auf. Der erste Abschnitt 10 ist dazu geeignet, einen Wärmeeintrag 31 aufzunehmen und dadurch ein Kühlfluid 25 zu verdampfen. Eine solche Verdampfung 32 des Kühlfluids 25 ist in FIG 7 schematisch dargestellt. Der erste Abschnitt 10 ist zumindest teilweise als Hohlkörper ausgebildet, so dass der erste Abschnitt 10 ein Reservoir 14 für das Kühlfluid 25 bildet. Ebenso ist im ersten Abschnitt 10 ein Kanal 12 ausgebildet, durch den Kühlfluid 25 leitbar ist. Der Kanal 12 ist im Inneren des ersten Abschnitts 10 ausgebildet und ist hydraulisch mit einem Kanal 42 in der Biegestruktur 40 verbunden. Der Kanal 42 in der Biegestruktur 40 wiederum ist hydraulisch mit einem zweiten Kanal 22 im zweiten Abschnitt 20 hydraulisch verbunden. Hierdurch liegt insgesamt eine hydraulische Verbindung zwischen dem ersten und zweiten Abschnitt 10, 20, bzw. zwischen deren Kanälen 12, 22 vor. Der zweite Abschnitt 20 ist ebenso zumindest teilweise als Hohlkörper ausgebildet und bildet auch ein Reservoir 24 für das Kühlfluid 25. Der zweite Abschnitt 20 ist dazu ausgebildet, Wärme über eine Wärmeabfuhr 33 an eine nur schematisch gezeigte Wärmesenke 18 abzugeben. Der zweite Abschnitt 20 ist dazu ausgebildet, dampfförmiges Kühlfluid 25 zu kondensieren. Eine derartige Kondensation 34 ist in FIG 7 korrespondierend zur Verdampfung 32 schematisch gezeigt.

Die Biegestruktur 40 ist mäanderförmig ausgebildet und umfasst eine Mehrzahl an Längsstegen 44, die sich im Wesentlichen parallel zu einer Biegeachse 15 erstrecken, um die die Biegestruktur 40 wiederholt biegbar ist. Die Biegeachse 15 ist dabei im Wesentlichen parallel zu einer Kante 11, 21 des ersten und zweiten Abschnitts 10, 20 ausgerichtet. Die Längsstege 44 sind über Querstege 46 miteinander verbunden, so dass die Mäanderform der Biegestruktur 40 ausgebildet ist. Der Kanal 42 der Biegestruktur 40 erstreckt sich durch die Längsstege 44 und Querstege 46. Einer Mehrzahl an Längsstegen 44 ist einstückig mit mindestens einem Querkanal 43 ausgebildet, durch den dem strömenden Kühlfluid 25 im entsprechenden Längssteg 44 eine Vorzugsrichtung aufgeprägt wird. Hierzu zweigen die Querkanäle 43 in den entsprechenden Längsstegen 44 im Wesentlichen diagonal ab. Hierdurch ist insbesondere für verdampftes Kühlfluid 25 die Strömungsrichtung unabhängig von einer vorliegenden Biegung und/oder räumlichen Lage der Kühlvorrichtung 30 dem Kühlfluid 25 eine Strömungsrichtung aufprägbar und so eine Funktionstüchtigkeit der Kühlvorrichtung 30 sichergestellt werden. Für eine Rückführung von kondensiertem Kühlfluid 25 kann der zweite Abschnitt 20 mit einer weiteren, nicht gezeigten Biegestruktur 40 verbunden sein. Die Querkanäle 43 sind frei von beweglichen Teilen und bieten dadurch eine erhöhte Zuverlässigkeit. Innerhalb des Kanals 42 der Biegestruktur 40 liegt für verdampftes Kühlfluid 25 eine erste Fließrichtung 27 vor und für kondensiertes Kühlfluid 25. Dadurch und in Verbindung mit dem im Wesentlichen plattenförmigen ersten und zweiten Abschnitt bildet die Kühlvorrichtung 30 eine planare Zweiphasenkühlung, also eine planare Heatpipe oder einen planaren Thermosiphon. Die Mäanderform der Biegestruktur 40 macht diese um die Biegeachse 15 wiederholt biegbar. Insbesondere wird durch die Mäanderform mechanisch im Wesentlichen das Prinzip eines Balgs verwirklicht. Eine entsprechende Biegung ist in FIG 7 als Pfeil 49 versinnbildlicht. Die Biegestruktur 40 übt in einem gebogenen Zustand eine Rückstellkraft aus, durch die die Kühlvorrichtung 30 in den gezeigten ungebogenen Zustand zurückstrebt. Auch bei einem Biegen 49 um die Biegeachse um 90° oder mehr liegen in der Biegestruktur 40 überwiegend, bevorzugt ausschließlich, elastische Verformungen vor. Die Kühlvorrichtung 30 ist auch so weit wiederholt um die Biegeachse 15 biegbar, dass sich Oberflächen des ersten und zweiten Abschnitts 10, 20 gegenüberliegen. Durch die Form der Biegestruktur 40 ist eine Plastifizierung und/oder Rissbildung im Kunstharz 48 beim Biegen 49 minimiert, so dass die Biegestruktur 40 dazu geeignet ist, einer erhöhten Zahl an Biegezyklen standzuhalten. Die Biegestruktur 40 mit dem darin ausgebildeten Kanal 42 ist beispielsweise durch additive Fertigung herstellbar. Alternativ oder ergänzend kann die Form der Biegestruktur 40 aus einem flächigen Halbzeug durch spanabhebende Bearbeitung oder Stanzen hergestellt werden. Die beanspruchte Kühlvorrichtung 30 ist somit in einfacher und wirtschaftlicher Weise herstellbar. Die Kühlvorrichtung 30 nach FIG 7 stellt insgesamt im Wesentlichen eine wiederholt biegbare planare Zweiphasenkühlung dar. Die Kühlvorrichtung 30 ist dazu geeignet, in einem nicht näher gezeigten Umrichter 50 eingesetzt zu werden, der winkelig aufgebaut ist. Ebenso ist die Kühlvorrichtung 30 zur Verwendung in einem nicht näher gezeigten faltbaren Elektronikgerät 60 eingesetzt zu werden. Zur Kühlvorrichtung 30 liegt ein Simulationsprogrammprodukt 70 vor, das dazu ausgebildet ist, ein Betriebsverhalten der Kühlvorrichtung 30 nachzustellen. Zum Betriebsverhalten kann ein mechanisches Verhalten, insbesondere eine mechanische Belastung von Längsstegen 44 und/oder Querstegen 46 der Biegestruktur 40, ein Verdampfungsverhalten, ein Fließverhalten und/oder Kondensationsverhalten des Kühlfluids 25 umfassen. Abhängig vom vorliegenden Biegezustand und ihrer räumlichen Lage ist die Kühlvorrichtung 30 im ungebogenen Zustand simulierbar. Die Einwirkung der Schwerkraft auf das Kühlfluid 25 ist als veränderliches Vektorfeld entlang des ersten Abschnitts 10, des zweiten Abschnitts 20 und/oder der Biegestruktur 40 darstellbar. Dies erlaubt eine vereinfachte Simulation mit reduziertem Rechenaufwand. Das Simulationsprogrammprodukt ist als sogenannter Digitaler Zwilling der Kühlvorrichtung 30 ausgebildet.

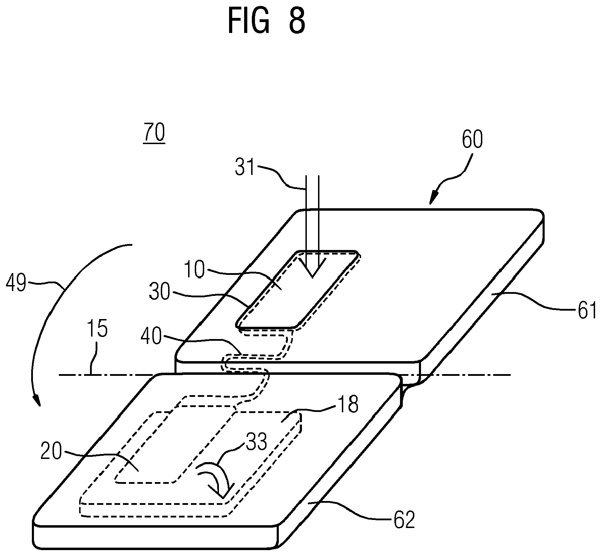

Eine Ausführungsform eines beanspruchten faltbaren Elektronikgeräts 60 ist in FIG 8 schematisch in einem ungebogenen Zustand gezeigt. Das faltbare Elektronikgerät 60 ist als faltbares Smartphone ausgebildet und umfasst einen ersten Geräteabschnitt 61, der um eine Biegeachse 15 wiederholt biegbar mit einem zweiten Geräteabschnitt 62 verbunden ist. Ein Biegen bzw. Falten des faltbaren Elektronikgeräts 60 erfolgt entlang des Pfeils 49 in FIG 8. Im ersten Geräteabschnitt 61 erfolgt während des Betriebs eine Wärmefreisetzung, durch die ein Wärmeeintrag 31 in einen ersten Abschnitt 10 einer Kühlvorrichtung 30 erfolgt. Die Kühlvorrichtung 30 weist auch einen zweiten Abschnitt 20 auf, der in thermischem leitendem Kontakt zu einer Wärmesenke 18 steht, die als Kühlkörper ausgebildet ist. Die Kühlvorrichtung 30 ist dazu ausgebildet, die über den Wärmeeintrag 31 in den ersten Abschnitt 10 eingebrachte Wärme aus dem ersten Geräteabschnitt 61 zu einer Wärmeabfuhr 33 in die Wärmesenke 18 im zweiten Geräteabschnitt 62 zu transportieren. Der erste Abschnitt 10 und der zweite Abschnitt 20 der Kühlvorrichtung 30 sind über eine Biegestruktur 40 miteinander verbunden, die im Wesentlichen mäanderförmig ausgebildet ist. Die Biegestruktur 40 gehört zur Kühlvorrichtung 30 und ist dazu geeignet, in einem gebogenen Zustand eine Rückstellkraft auszuüben, durch die das faltbare Elektronikgerät 60 in den in FIG 8 gezeigten ungebogenen Zustand zurückstrebt. Die Kühlstruktur 30 kann insbesondere nach einer der Ausführungsformen gemäß einer der FIG 1 bis FIG 7 ausgebildet sein. Die Kühlvorrichtung 30 wird ferner durch ein nicht näher gezeigtes Simulationsprogrammprodukt 70 in seinem Betriebsverhalten nachgestellt. Das Simulationsprogrammprodukt 70 ist hierbei als Digitaler Zwilling der Kühlvorrichtung 30 oder als Digitaler Zwilling des faltbaren Elektronikgeräts 60 ausgebildet.

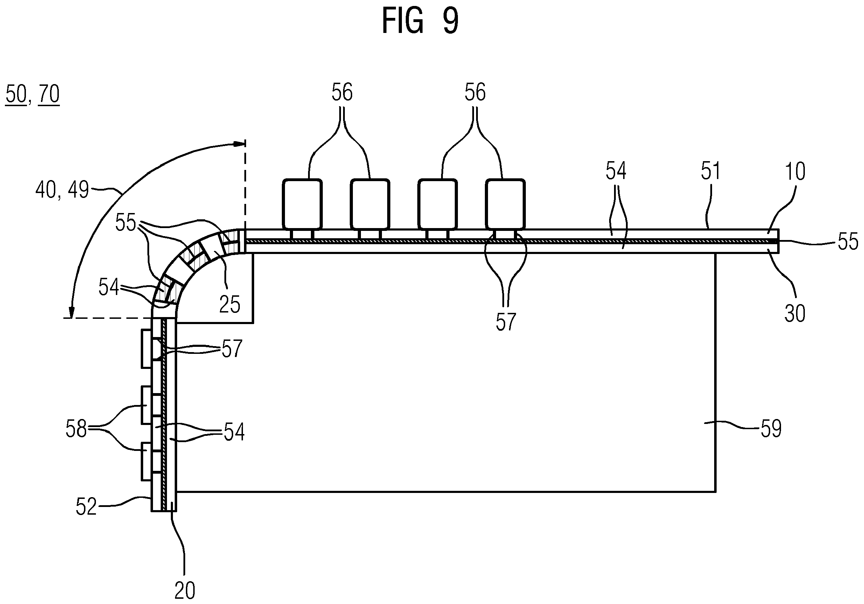

FIG 9 zeigt schematisch in einem Längsschnitt eine Ausführungsform eines beanspruchten Umrichters 50. Der Umrichter 50 umfasst eine erste Leiterplatte 51, auf der eine Mehrzahl an Kondensatoren 56 angeordnet ist. Die Kondensatoren 56 sind über Durchkontaktierungen 57 elektrisch mit einer Leiterlage 55 verbunden, die zwischen Dielektrikumlagen 54 angeordnet ist. Die erste Leiterplatte 59 ist auf einer Verankerung 59 befestigt. Weiter umfasst der Umrichter 50 eine zweite Leiterplatte 52, die ebenfalls eine Leiterlage 55 zwischen Dielektrikumlagen 54 aufweist. Die zweite Leiterplatte 52 ist ebenso an der Verankerung 59 befestigt. Auf der zweiten Leiterplatte 52 ist eine Mehrzahl an Leistungshalbleitern 58 angeordnet, die über Durchkontaktierungen 57 mit der Leiterlage 55 in der zweiten Leiterplatte 52 verbunden sind. Die erste und zweite Leiterplatte 51, 52 sind winkelig, nämlich im Wesentlich in einem 90°-Winkel, zueinander angeordnet. Die zugehörige Biegung 49 erfolgt bei einer Montage des Umrichters 50. Die erste und zweite Leiterplatte 51, 52 sind über eine Biegestruktur 40 miteinander verbunden, die wiederholt biegbar ist. Die Biegestruktur 40 ist hierbei gemäß einer Biegestruktur 40 nach einer der FIG 1 bis FIG 7 ausgebildet. Des Weiteren ist erstreckt sich die Leiterlage 55 auch durch die Biegestruktur 40. Die erste und zweite Leiterplatte 51, 52 gehören ebenso zu einer Kühlvorrichtung 30 und bilden entsprechend deren ersten und zweiten Abschnitt 10, 20, zwischen denen Wärme zu transportieren ist. Dementsprechend ist die erste Leiterplatte 51 einstückig mit dem ersten Abschnitt 10 der Kühlvorrichtung 30 ausgebildet und die zweite Leiterplatte 52 einstückig mit dem zweiten Abschnitt 20 der Kühlvorrichtung 30. Dementsprechend ist die Kühlvorrichtung 30 gemäß einer Ausführungsform wie in einer der FIG 1 bis FIG 7 ausgebildet. Das Konzept einer entsprechenden Kühlvorrichtung 30 ist durch eine darin aufgenommene Leiterlage 55 ergänzbar, so dass die Abschnitte 10, 20 der Kühlvorrichtung 50 gleichzeitig als Leiterplatten 51, 52 dienen. Hierdurch wird eine verbesserte thermische Anbindung an die Leistungshalbleiter 58 und/oder die Kondensatoren 56 erzielt. Der beanspruchte Umrichter 50 ist dadurch für komplexe Montagesituationen auslegbar, was wiederum eine kompakte Auslegung des Umrichters 50 erlaubt. Gleichermaßen ist der Umrichter 50 durch seine Biegsamkeit in einfacher Weise demontierbar, und dadurch wartbar. Die Kühlvorrichtung 30 wird ferner durch ein nicht näher gezeigtes Simulationsprogrammprodukt 70 simuliert, das als Digitaler Zwilling des Kühlvorrichtung 30 oder des Umrichters 50 ausgebildet ist.

## Patentansprüche

1. Kühlvorrichtung (30), umfassend einen ersten und einen zweiten Abschnitt (10, 20), die jeweils plattenförmig ausgebildet sind, und in denen jeweils zumindest ein Kanal (12, 22) für ein Kühlfluid (25) ausgebildet ist, wobei der erste und zweite Abschnitt (10, 20) über eine Biegestruktur (40) um eine Biegeachse (15) relativ zueinander wiederholt schwenkbar verbunden sind, **dadurch gekennzeichnet, dass** die Biegestruktur (40) zu einem Ausüben einer Rückstellkraft in einem gebogenen Zustand ausgebildet ist und zumindest einen Kanal (12) im ersten Abschnitt (10) mit einem Kanal (22) im zweiten Abschnitt (20) hydraulisch verbindet.

2. Kühlvorrichtung (30) nach Anspruch 1, **dadurch gekennzeichnet, dass** die Biegestruktur (40) einstückig mit dem ersten und zweiten Abschnitt (10, 20) ausgebildet ist.

3. Kühlvorrichtung (30) nach Anspruch 1 oder 2, **dadurch gekennzeichnet, dass** die Biegestruktur (40) zur Reduzierung einer plastischen Verformung beim Biegen mäanderförmig oder mehrfach Z-förmig ausgebildet ist, oder die Biegestruktur (40) als eine Mehrzahl an verbundenen umlaufenden Strukturen (47) ausgebildet ist.

4. Kühlvorrichtung (30) nach Anspruch 3, **dadurch gekennzeichnet, dass** die Biegestruktur (40) Längsstege (44) umfasst, die sich entlang der Biegeachse (15) erstrecken, oder Z-Stege (45) umfasst, die sich in einem gebogenen Zustand windschief zur Biegeachse (15) erstrecken.

5. Kühlvorrichtung (30) nach einem der Ansprüche 1 bis 4, **dadurch gekennzeichnet, dass** die Kühlvorrichtung (10) als planare Heatpipe, planare pulsierenden Heatpipe, oder als ein planarer Thermosiphon ausgebildet ist.

6. Kühlvorrichtung (30) nach einem der Ansprüche 1 bis 5, **dadurch gekennzeichnet, dass** die Biegestruktur (40) eine Mehrzahl an Querkanälen zu einem Aufprägen einer Vorzugsrichtung einer Fluidströmung zwischen dem ersten und zweiten Abschnitt (10, 20) aufweist und/oder dass die Biegestruktur () zu einem Aufprägen einer Vorzugsrichtung einer Fluidströmung abschnittsweise als Teslaventil (41) ausgebildet ist.

7. Kühlvorrichtung (30) nach einem der Ansprüche 1 bis 6, **dadurch gekennzeichnet, dass** im ersten Abschnitt (10), im zweiten Abschnitt (20) und/oder der Biegestruktur (30) ein erster Kanal (12, 22, 42) mit einer ersten Breite und ein zweiter Kanal (12, 22, 42) mit einer zweiten Breite ausgebildet sind, wobei die erste Breite geringer ist als die zweite Breite.

8. Kühlvorrichtung (30) nach einem der Ansprüche 1 bis 7, **dadurch gekennzeichnet, dass** die Biegestruktur (40) die gleiche Dicke aufweist wie der erste und zweite Abschnitt (10, 20) .

9. Kühlvorrichtung (30) nach einem der Ansprüche 1 bis 8, **dadurch gekennzeichnet, dass** der Kanal (42) in der Biegestruktur (40) durch zumindest eine Decklage aus einem Dielektrikum entlang einer Aufbaurichtung begrenzt ist.

10. Kühlvorrichtung (30) nach einem der Ansprüche 1 bis 9, **dadurch gekennzeichnet, dass** der Kanal (42) in der Biegestruktur (40) mit einer Gasbarriere-Schicht beschichtet ist.

11. Kühlvorrichtung (30) nach einem der Ansprüche 1 bis 10, **dadurch gekennzeichnet, dass** der erste und/oder zweite Abschnitt (10, 20) zumindest teilweise aus einem Kunststoff, einem Kunstharz (48) oder einem Verbundwerkstoff mit einem Kunstharz (48), insbesondere FR4, hergestellt ist.

12. Kühlvorrichtung (30) nach einem der Ansprüche 1 bis 11, **dadurch gekennzeichnet, dass** der erste und/oder zweite Abschnitt (10, 20) eine Leiterlage (55) umfasst und/oder mit einem SMD-Element versehen ist.

13. Umrichter (50), umfassend eine erste und eine zweite Leiterplatte (51, 52), die winkelig zueinander angeordnet sind und zusammen über eine Kühlvorrichtung (10) gekühlt sind, **dadurch gekennzeichnet, dass** die Kühlvorrichtung (10) nach einem der Ansprüche 1 bis 12 ausgebildet ist.

14. Faltbares Elektronikgerät (60), das als Smartphone, Tablet oder Notebook ausgebildet ist, umfassend einen ersten und einen zweiten Geräteabschnitt (61, 62), die relativ zueinander schwenkbar ausgebildet sind, und in dem eine Kühlvorrichtung (30) zu einem Wärmetransport vom ersten in den zweiten Geräteabschnitt (61, 62) angeordnet ist, **dadurch gekennzeichnet, dass** die Kühlvorrichtung (30) nach einem der Ansprüche 1 bis 12 ausgebildet ist.

15. Simulationsprogrammprodukt (70), das Befehle umfasst, die einen Computer bei ihrer Ausführung dazu veranlassen, ein Betriebsverhalten einer Kühlvorrichtung (30) nach einem der Ansprüche 1 bis 10, **dadurch gekennzeichnet, dass** (30) zu simulieren, **dadurch gekennzeichnet, dass** die Kühlvorrichtung (30) nach einem der Ansprüche 1 bis 13 ausgebildet ist.
